Europäisches Patentamt

European Patent Office

Office européen des brevets

(11) Publication number: **0 172 311**
**B1**

## EUROPEAN PATENT SPECIFICATION

(45) Date of publication of patent specification: **26.07.89**

(51) Int. Cl.⁴: **G 01 R 31/28, G 06 F 11/20**

(21) Application number: **85104574.0**

(22) Date of filing: **18.12.81**

(60) Publication number of the earlier application in accordance with Art. 76 EPC: **0 096 027**

(54) Memory element for a wafer scale integrated circuit.

(43) Date of publication of application:
**26.02.86 Bulletin 86/09**

(45) Publication of the grant of the patent:
**26.07.89 Bulletin 89/30**

(84) Designated Contracting States:
**BE CH DE FR LI NL SE**

(56) References cited:
**GB-A-2 128 381**
**US-A-3 913 072**

(73) Proprietor: **UNISYS CORPORATION**
**1, Burroughs Place**
**Detroit Michigan 48232 (US)**

(72) Inventor: **Chamberlain, John Terence**
**8 Manley Road**
**Macclesfield Cheshire SK11 7UU (GB)**

(74) Representative: **Kirby, Harold Douglas Benson et al**
**G.F. Redfern & Company Marlborough Lodge 14 Farncombe Road**
**Worthing West Sussex BN11 2BT (GB)**

# EP 0 172 311 B1

**Description**

The present invention relates to an integrated circuit memory comprising a plurality of self-testing shift register cells operable in response to a controller to execute a test and connect routine to form a long chain, shift register branched labyrinth across the face of the integrated circuit and thereafter to store data in the long chain and to access that data via a secondary, parallel, fast chain.

It is known to fabricate many individual circuits on a silicon wafer. The wafer is generally of the order of 6 cm in diameter and may contain many hundreds of circuits. It is the practice thereafter to cut the wafer to free each individual circuit, and to individually package each circuit. Integrated circuit packaging is area and volume inefficient. The package, because of clearances required for headers and leads, is many times the area and thickness of the individual circuit. The larger the circuit which can be accommodated, the more efficient the packaging becomes. As a limit, the packaging becomes most efficient when the entire wafer can be accommodated as a single circuit.

Manufacturing tolerances mean that only a proportion of the surface of any wafer is correctly processed during integrated circuit manufacture. Areas not correctly processed yield non-working components. The likelihood of an entire wafer being fabricated as a single, working circuit is so low as to render any attempt to make such a device impractical.

It is known to fabricate an integrated circuit wafer, for use as a single device, by subdividing the wafer into plural, identical elements and providing test facilities whereby each of the elements may be tested, working elements being incorporated in the operation of the wafer and non-working elements being ignored.

Such methods include common electrical connections to each of the elements, undesirable because a failure in the common structure renders the entire wafer inoperable. Also included are methods where elements test and connect to adjacent elements of the wafer 10 across boundaries therebetween, but where the proportion of working elements which are ignored by the test routine is unacceptably high.

Such whole-wafer integrated circuits are notably employed for use in data storage as memories. Typically, the individual elements contain shift registers which are connected, whenever that element is tested and found to be working, as part of a long shift register configured from the tested and working elements on the wafer. Problems exist in the slowness of data deposition or acquisition in such a structure.

A whole wafer integrated circuit is vulnerable to fabrication or operational faults which cause the power supply to individual elements therein to be short circuited. It is known to employ fusible links to isolate such elements and allow the others to continue functioning. The incorporation of fusible links introduces yet another source of possible failures, and does not allow the minimisation of the power requirement of the wafer by switching off individual elements that might not be required to be incorporated in the operation of the wafer.

It is therefore desirable to provide an integrated circuit, suitable for use as a memory and for fabrication as a whole-wafer device, comprising a plurality of individual elements having the minimum of common circuitry, where the elements may be tested and incorporated into the operation of the wafer in a manner which allows for the incorporation of a high proportion of all functional elements, where the coupling of power to an element is selectable, and wherein data may be deposited or retrieved rapidly.

European Patent Application EP—A—0 080 834, published 08.06.83, discloses an integrated circuit plural cellular array wherein a cell is provided with a plurality of data processing elements such as memory elements concatenated into a serial data processing system by growth of a cellular array. The present application seeks to provide improvement thereover by providing that the concatenated memory elements form an associative memory wherein data is crossed over between a fast data access line and a slow serial shift register data storage line in response to control characters in a parallel control character line, the nature of the memory being such that there is no requirement to keep track of the position of any particular data record stored in the concatenated data storage shift registers since each record is essentially self-selecting by virtue of seeking a match between address characters in the fast data access line and characters emerging from each long data storage shift register.

United Kingdom Patent 1,377,859 discloses a wafer scale integrated circuit polycellular array wherein memory storage elements are concatenated to form a large scale memory which is accessed by means of a fast data line. Each memory element is in receipt of common command signals and comprises a comparison element for comparing data circulating in a chain of data storage shift registers with data passing through the fast access shift register chain. If a match is found, a crossover switch is activated allowing transfer between fast access data line and the chain of long data storage shift registers. The present application seeks to provide improvement over the memory element disclosed in UK Patent 1,377,859 by providing for control characters to be fed in parallel with the fast data access line and the slow long shift register data storage line to condition the match detection operation to provide an associative memory wherein the position of a record is immaterial to its rapidly being found and wherein selectable parts of a record may be used as an address for that record.

The present invention consists in an integrated circuit comprising data storage element including; a data storage shift register, a data access shift register, a cross-over switch for crossing-over the outputs of said data storage shift register and said data access shift register, and a data comparator for performing a comparison operation between the first bit in said data storage shift register and the output of said data

2

access shift register, said data comparator being operable to provide an output indicative of a mismatch having occurred therebetween during the course of said operation, said integrated circuit being characterised by said data storage element comprising a control character shift register; by said data comparator being operable in response to the first presentation of a first control character to said control character shift register to commence said comparison operation; by said data comparator being operable in response to subsequent presentations of said first control character to said control character shift register alternately to suspend and to resume said comparison operation; by said cross-over switch being operable in response to the first presentation of a second control character to said control character shift register to commence said crossing-over if and only if said data comparator does not provide said output indicative of a mismatch, and wherein said cross-over switch is operable to abandon said crossing-over in response to the subsequent representation of said second control character to said control character shift register.

In the following description and claims functional coupling is defined as coupling for the transfer of data and/or control signals.

EP—A—0 096 027 from which the present application is divided has the same particular description and drawings as the present application. The claims of EP—A—0 096 027 relate particularly to the arrangements by which every cell which has had the functional coupling confirmed responds to the common command signal by providing an approach to a neighbouring cell and by which every cell which has not received the functional coupling is capable of accepting said functional coupling if it receives an approach from a neighbouring cell.

In a preferred embodiment an integrated circuit comprises a plurality of cells preferably on the same wafer. The cells are preferably provided with a common control signal to which each cell is operable to respond by executing a functional test, cells which have already passed the test being operable to initiate the test in any neighbouring cell in a selectable direction provided the neighbouring cell has not already undergone the test, and to functionally link to the neighbouring cell if the neighbouring cell passes the test.

The selected direction of test preferably rotates by fixed increments or decrements after each functional test cycle. The cells are preferably square, in which case the direction of test preferably decrements or increments by 90°.

The cells preferably test and interconnect to form a branched labyrinth structure over the surface of the wafer. The testing preferably starts at an input port. The tests are preferably conducted under instruction from a controller, connected at the input port.

The cells are preferably identical. The cells are preferably interconnectable to form a chain shift register memory looping once around the labyrinth.

Each cell preferably comprises a state machine for conducting the functional test supervision. The cells preferably comprise a switching matrix at each boundary edge to each neighbouring cell. The matrix preferably allows that signals pass in and out of the cell when instructed in a first manner, allows signals to loop around the cell when instructed in a second manner, and allows a form of coupling required for testing when instructed in a third manner.

The chain shift register memory preferably comprises a data storage chain in parallel with a data access chain and a control character chain, together with cross-over switches operable to cross-over the data in the data storage chain and the data access chain whenever the register in the control character chain which is associated with a switch contains a predetermined character. The individual registers in the data access chain and the control character chain are preferably only one bit long.

The chain shift register memory preferably comprises a data comparison element for comparing the output of each data storage register with the output of its associated data access register and activating the cross-over switch when a data match is found and a predetermined character is in the associated control register to provide a content addressable feature.

The supply of power to each cell, whether in whole or in part, is preferably dependent upon whether or not that cell is functionally coupled to another.

The invention is further described, by way of an example, by the following description in conjunction with the appended drawings, in which:

Figure 1 shows the cells and the coupling port on the wafer.

Figure 2 shows the interconnections of the cells.

Figure 3 shows the connections of the coupling port.

Figure 4 shows details of the individual cells.

Figures 5A to 5F show coupling modes of the switching matrices.

Figure 6 shows the intercoupling between matrices on adjacent cells.

Figure 7 shows the data comparison facility on each matrix.

Figure 8 shows a schematic of the state machine.

Figures 9A to 9L show the growth of the labyrinth.

Figure 10 shows a labyrinth at an advanced growth stage.

Figure 11 shows an advanced-growth labyrinth on a wafer with inoperative cells.

Figure 12 shows the manner of coupling of the wafer to a host system.

Figure 13 shows the path of data and control characters during cell test.

Figure 14 shows the test pattern path through a cell during a first part of the test.

Figure 15 shows the test pattern path through a cell during a second part of the test.

Figure 16 shows the state diagram of the state machine.

Figure 17 shows the path of the serial shift register memory established by the testing.

Figure 18 shows details of the shift register chain.

Figures 19A to 19C show the movement of data and control characters through the chain.

Figure 20 shows a modification to make the chain into a content-addressable memory.

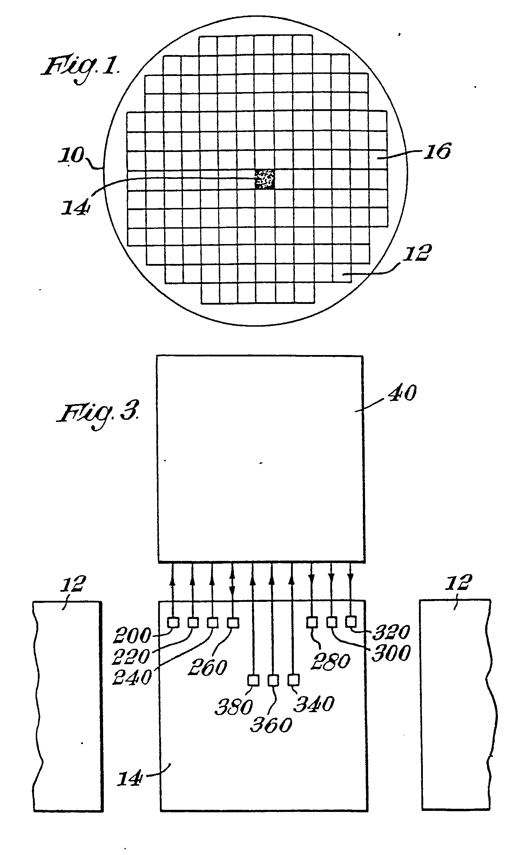

Figure 1 shows the cells on the wafer.

A full size silicon wafer 10 has a fabricated thereon a plurality of square, contiguous, memory storage cells 12 in regular array arranged in a square tessellation. The site which should be occupied by one of the cells 12 is left blank to make a coupling port 14. Each cell 12 is operable to test a selectable one of its bordering neighbours, with the exception of the edge cells 16, which have one or more sides unbounded by a neighbour, and cannot therefore test in those directions.

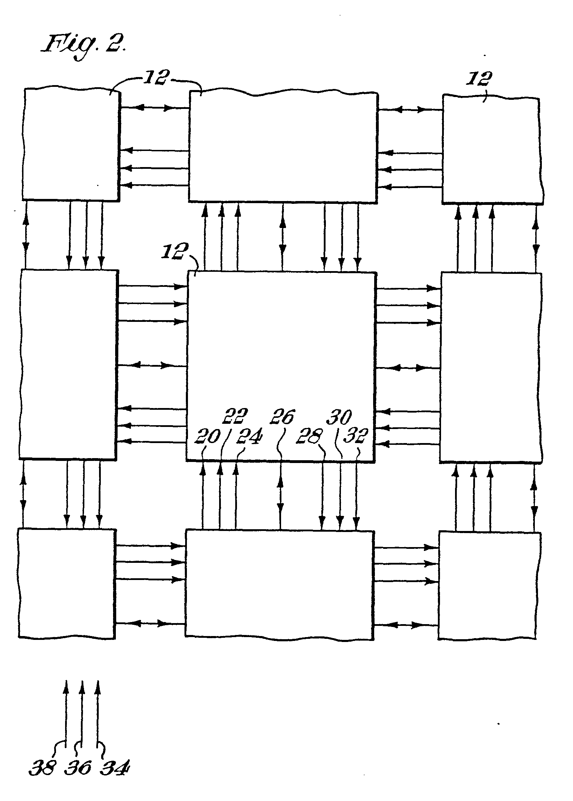

Figure 2 shows, in schematic form, the interconnections between cells 12 on the wafer 10.

Each of the cells 12 is coupled, along its boundary edges, with each of the four bordering cells. There are seven connections between bordering edges. A fast in line 20 conveys rapid transit data into each cell 12. A control in line 22 conveys control characters into the cell 12. A slow in line 24 conveys slow, shift register contained stored data between cells 12. A bidirectional control line 26 is used for cells 12 to signal to neighbouring cells 12 along their boundaries during testing. A slow out line 28 conveys slow, shift register stored data out of each cell. A control out line 30 conveys control characters out of each cell. A fast out line 32 conveys rapid transit data out of each cell 12. In addition, every cell 12 on the wafer 10 is coupled to a power line 34, for providing D.C. power to each cell 12, a clock line 36 for conveying a common clock signal to each cell 12, and a function line 38 for conveying common commands to each cell 12. These last three lines 34, 36, 38 are known as global lines, being common to all cells 12. For clarity these lines 34, 36, 38 are not shown connected to each cell 12, but it is to be understood that a pattern of metallisation carries and connects them to each cell 12 on the wafer 10.

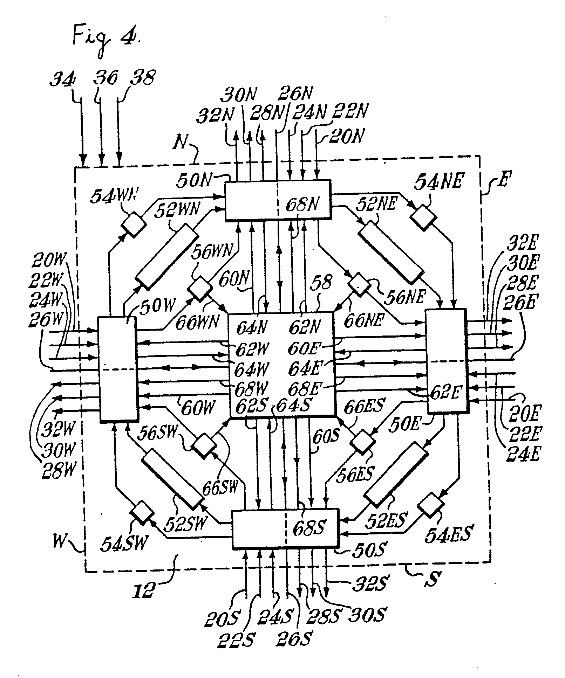

Figure 3 shows the coupling port 14.

One edge of the coupling port 14 is provided with pads for connecting the wafer 10 to the outside world. These pads are connected by gold wire bonding in the manner normal for integrated circuit manufacture, to external connections on the wafer enclosure. The pads connect to a first cell 40 which cannot test in the direction of the pads just as the edge cells 16 cannot test into the void. A fast out pad 320 carries rapid transit data out of the wafer 10. A control out pad 300 conveys control characters out of the wafer 10. A slow out pad 280 conveys slow, shift register stored data out of the wafer 10. A power in pad 340 conveys power to each cell 12 on the wafer 10 via the power line 34. A clock input pad 360 provides an input for the common clock line 36. A command input pad 380 provides an input to the function line 38. A command line pad 260 allows a command line signal to be linked to the first cell 40. A slow in pad 240 couples slow data into the wafer 10. A control in pad 220 couples control characters into the wafer 10. A fast in pad 200 couples rapid transit data into the wafer 10.

Figure 4 shows details of the individual cell 12 in the polycellular array on the wafer 10.

Each cell 12 has four sides, hereinafter referred to by the points of the compass, North N, South S, East E and West W. Each of the boundaries N, E, S, W is provided with a signal switching matrix, 50N, 50E, 50S and 50W respectively, hereinafter collectively referred to as 50 (NESW).

The matrices 50 (NESW) are interconnected by four data storage shift registers 52NE, 52ES, 52SW and 52WN respectively, the first letter suffix indicating the matrix 50 of origin and the second letter of the suffix indicating the matrix 50 of destination. The length of the shift registers 52 is immaterial to the operation of the present invention. In the particular case of the preferred embodiment they are 360 bits long. The shift registers 52NE, 52ES, 52SW and 52WN represent the data storage capacity of the cell 12.

The matrices 50 (NESW) are similarly interconnected by four single bit fast registers 54NE, 54ES, 54SW and 54WN respectively, the letter suffices having the same meaning as before. In just the same manner, four single bit control registers 56NE, 56ES, 56SW and 56WN are interconnected between the matrices 50(NESW) with the letter suffices yet again indicating the same information.

A state machine 58 controls the matrices 50(NESW) via connect signals on connect command couplings, one to each matrix 60N, 60E, 60S and 60W respectively, and cross-over signals on cross-over couplings 62N, 62E, 62S and 62W respectively. The state machine 58 is responsive to and operable to provide signals on the command lines 26N, 26E, 26S and 26W, these being the lines used to signal between adjacent state machines 58 in the polycellular array.

The power line 34, is coupled to every element in the cell 12, via the state machine 58, the clock line 36 is coupled to every element in the cell 12, and the function line 38 is coupled to the state machine 58.

Each of the matrices 50(NESW) contains a comparison element for bit-by-bit comparisons of incoming and outgoing data. The detection of an error in the comparison is signalled to the state machine 58 via the error couplings 64N, 64E, 64S and 64W.

The state machine is responsive to the contents of the control shift registers 56NE, 56ES, 56SW and 56WN and is coupled thereto via the control couplings 66NE, 66ES, 66SW and 66WN respectively.

When the state machine 58 provides the connect signal to any one of the matrices 50N, 50E, 50S or 50W that matrix couples the contents of its incoming fast register 54WN, 54NE, 54ES or 54SW respectively, into the fast out line 32N, 32E, 32S or 32W respectively and couples the contents of the incoming control register 56WN, 56NE, 56ES or 56SW respectively into the control out line 30N, 30E, 30S or 30W respectively, couples the output of the incoming slow register 52WN, 52NE, 52ES or 52SW respectively into the slow out line 28N, 28E, 28S, or 28W respectively couples the data arriving on the slow in line 24N, 24E, 24S or 24W respectively as the input to the outgoing shift register 52NE, 52ES, 52SW or 52WN respectively, couples the control bits arriving on the control in line 22N, 22E, 22S or 22W respectively to the outgoing control register 56NE, 56ES, 56SW or 56WN respectively, and couples the data arriving on the fast in line 20N, 20E, 20S or 20W respectively as the input to the outgoing fast register 54NE, 54ES, 54SW or 54WN respectively.

When the state machine 58 does not provide the connect command to one of the matrices 50N, 50E, 50S or 50W, that matrix couples the output of the incoming slow register 52WN, 52NE, 52ES or 52SW respectively as the input to the outgoing slow register 52NE, 52ES, 52SW or 52WN respectively, couples the output of the incoming fast register 54WN, 54NE, 54ES or 54SW respectively as the input to the outgoing fast register 54NE, 54ES, 54SW or 54WN respectively, and couples the output of the incoming control register 56WN, 56NE, 56ES or 56SW respectively as the input to the outgoing control register 56NE, 56ES, 56SW or 56WN respectively.

Notwithstanding the above, whenever the state machine provides the cross-over command to any one of the matrices 50N, 50E, 50S or 50W, should the state machine 58 also be providing the connect command, that matrix 50N, 50E, 50S or 50W changes its function from the foregoing by coupling the output of the incoming slow register 52WN, 52NE, 52ES or 52SW respectively into the fast out line 32N, 32E, 32S or 32W respectively, coupling the output of the incoming fast register 54WN, 54NE, 54ES or 54SW respectively into the slow out line 28N, 28E, 28S or 28W respectively, coupling the data on the slow in line 24N, 24E, 24S or 24W respectively as the input to the outgoing fast register 54NE, 54ES, 54SW or 54WN respectively, and coupling the data on the fast in line 20N, 20E, 20S or 20W respectively as the input to the outgoing slow register 52NE, 52ES, 52SW or 52WN, and should the state machine 58 not be providing the connect command, that matrix 50N, 50E, 50S or 50W changes its function by coupling the output of the incoming slow register 52WN, 52NE, 52ES or 52SW respectively as the input to the outgoing fast register 54NE, 54ES 54SW or 54WN respectively and coupling the output of the incoming fast register 54WN, 54NE, 54ES or 54SW respectively as the input to the outgoing slow register 52NE, 52ES, 52SW or 52WN respectively.

The state machine 58 further provides, to the matrices 50N, 50E, 50S and 50W, a test signal via the test connectors 68N, 68E, 68S and 68W respectively. Whenever a matrix 50N, 50E, 50S or 50W is in receipt of the test signal it responds by coupling the output of the incoming control register 56WN, 56NE, 56ES or 56SW respectively as the input to the outgoing control register 56NE, 56ES, 56SW or 56WN respectively and as the input to the control out line 30N, 30E, 30S or 30W respectively, couples the output of the incoming fast register 54WN, 54NE, 54ES or 54SW respectively as the input to the outgoing fast register 54NE, 54ES, 54SW or 54WN respectively and as the input to the fast out line 32N, 32E, 32S or 32W respectively, and couples the output of the incoming slow register 52WN, 52NE, 52ES or 52SW respectively as the input to the outgoing slow register 52NE, 52ES, 52SW or 52WN respectively, and as the input to the slow out line 28N, 28E, 28S or 28W respectively, while still responding to the cross-over instruction to swap the fast and slow data whenever the state machine 58 provides the cross-over instruction.

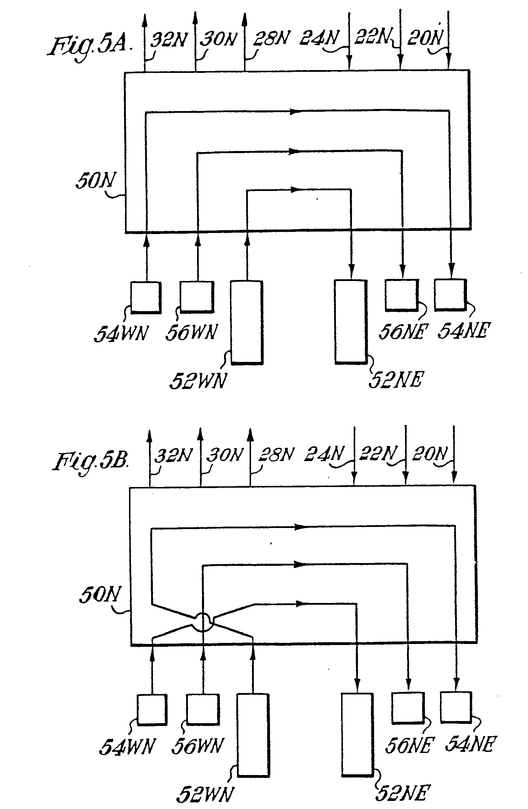

Figures 5A through 5F show the coupling function of the North matrix 50N in schematic form, it being understood that the other three matrices 50E, 50S and 50W function in the same manner.

Figure 5A shows the situation where the matrix 50N is in receipt of neither the cross-over instruction, the connect instruction nor the test signal.

Figure 5B shows the situation where the matrix 50N is in receipt of neither the connect instruction nor the test signal but is in receipt of the cross-over command.

Figure 5C shows the situation where the matrix 50N is in receipt of the connect command.

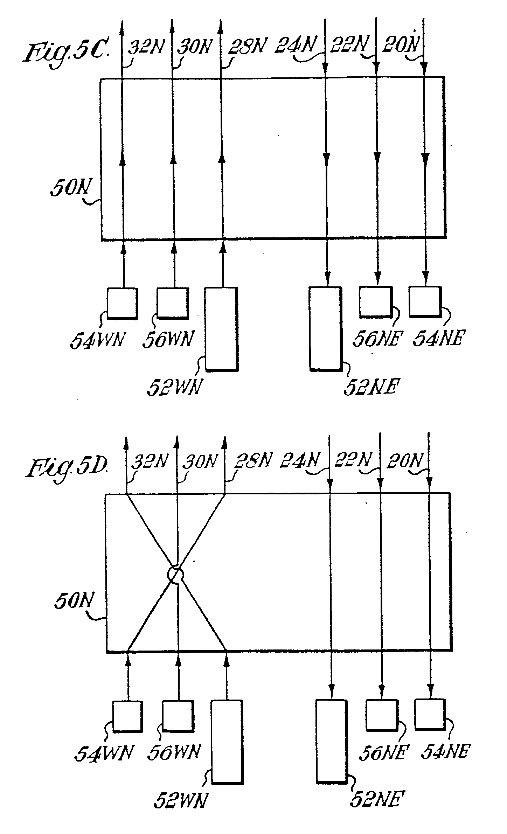

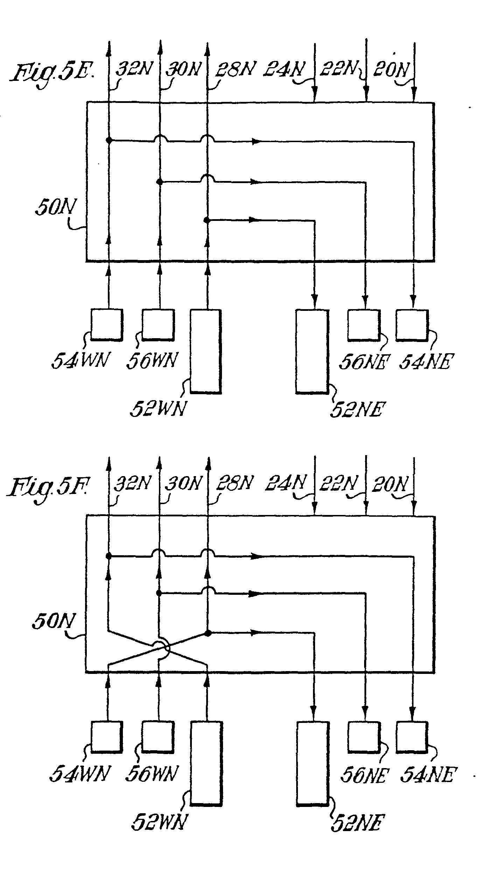

Figure 5D shows the situation where the matrix 50N is in receipt of both the connect command and the cross-over command.

Figure 5E shows the situation when the matrix is in receipt of the test signal.

Figure 5F shows the situation where the matrix 50N is in receipt of both the test signal and the cross-over command.

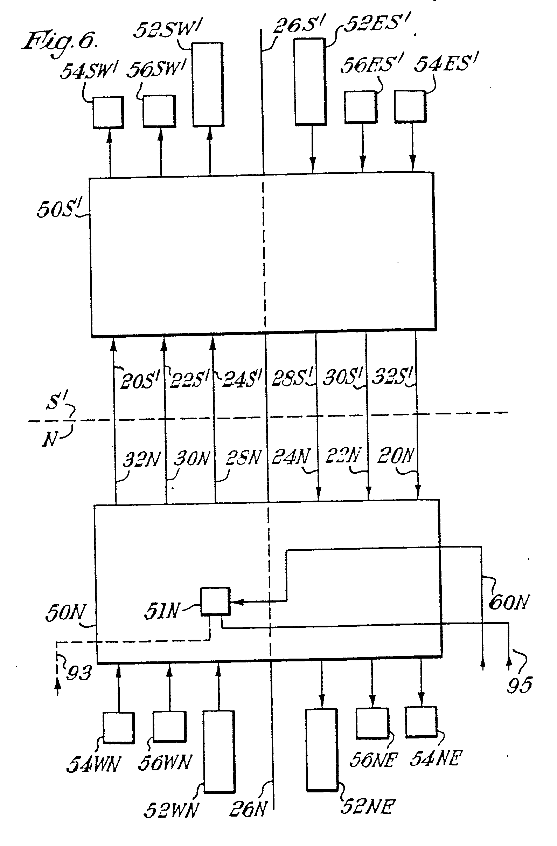

Figure 6 shows, in schematic detail, the intercoupling across the Northern edge N of the cell 12, it being understood that the intercoupling across the three remaining edges E, S and W is the same. A flip-flop, the CON F/F 51N is set by the application of either the test command or the connect command and an establish connection signal on the connector 93. The output of CON F/F 51N is used to maintain the permanent coupling across the boundary N to the adjacent matrix 50S, consistently with Figures 5C and 5D, when either the test command or the connect command is removed by state machine 58 after determining that such a permanent connection should be established. The flip-flop 51N is reset by a master reset signal on the connector 95.

The superscript on any number or letter is indicative of the part indicated by that number or letter being a member of the adjacent cell.

The fast out line 32N couples to the fast in line 20S' of the adjacent cell. The control out line 30N couples to the control in line 22S' of the adjacent cell. The slow out line 28N couples to the slow in line 24S' of the adjacent cell. The command line 26N couples to the command line 26S' of the adjacent cell. The fast out line 32S' of the adjacent cell couples to the fast in line 20N. The control out line 30S' of the adjacent cell couples to the control in line 22N. The slow out line 28S' of the adjacent cell couples to the slow in line 24N. These intercouplings allow adjacent state machines 58 to signal to one another via the command lines 26, and allow the transfer of data and control characters between corresponding registers in adjacent cells. In a similar manner, the Eastern face E would couple to an adjacent Western face, the Southern face S would couple to an adjacent Northern face, and the Western face W would couple to an adjacent Eastern face.

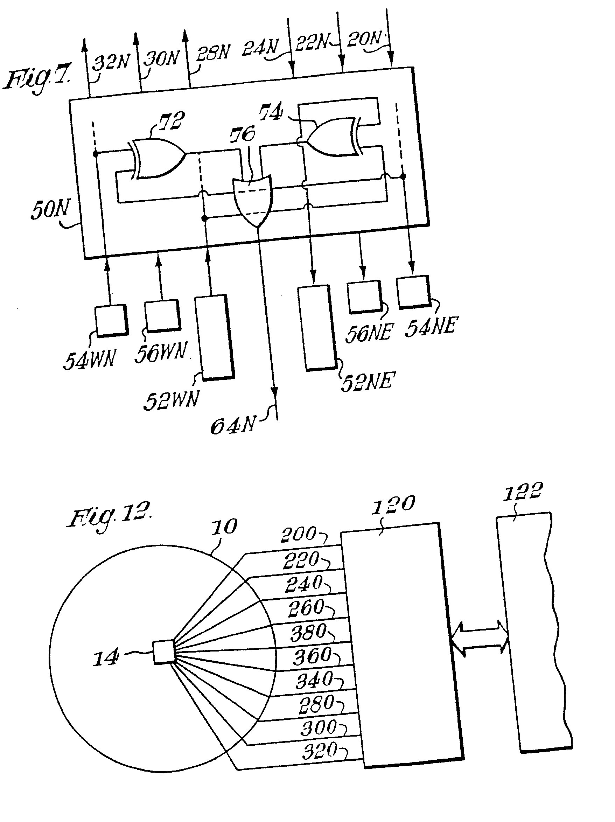

Figure 7 shows the manner in which the Northern matrix 50N detects and signals errors to the state machine 58, it being understood that the other three matrices 50E, 50S and 50W function in the same manner.

A first exclusive or gate 72 monitors the data arriving on the incoming fast in line 20N and going to the outgoing fast out line 32N. If the two data bits so presented are not the same, an error is indicated and the first exclusive or gate 72 provides a logically true output. In the same manner, a second exclusive or gate 74 monitors the data going out on the outgoing slow out line 28N and the data arriving on the incoming slow in line 24N and provides a logically true output if the data bits so delivered are not the same. The output of the first and second exclusive or gates 72 and 74 are logically combined by an or gate 76 whose output provides a logically true error indication on the error coupling 64N in the event of either data mismatch as described.

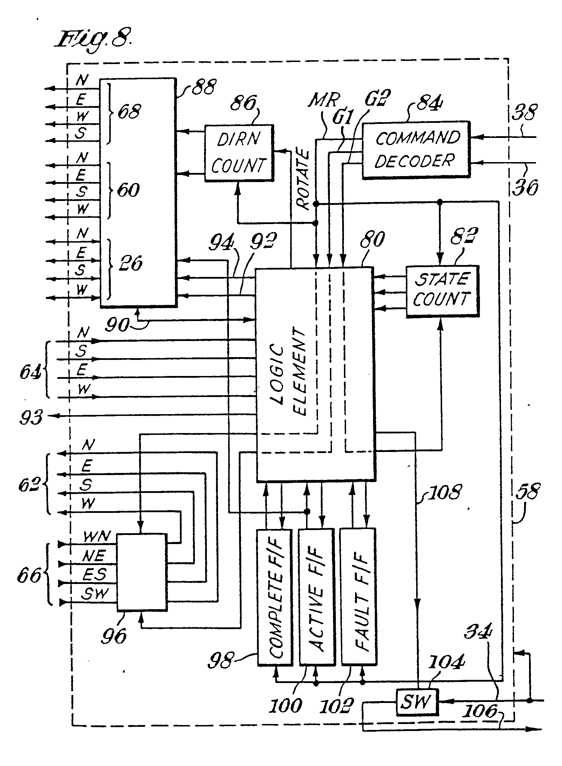

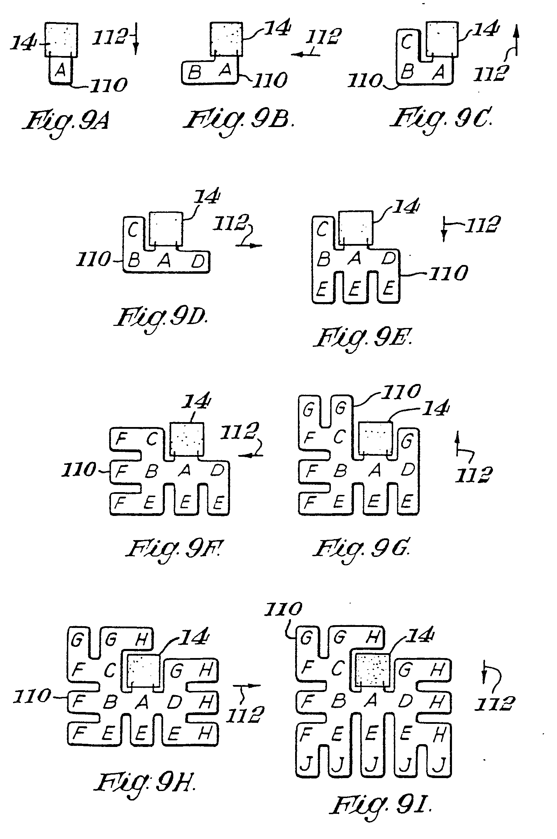

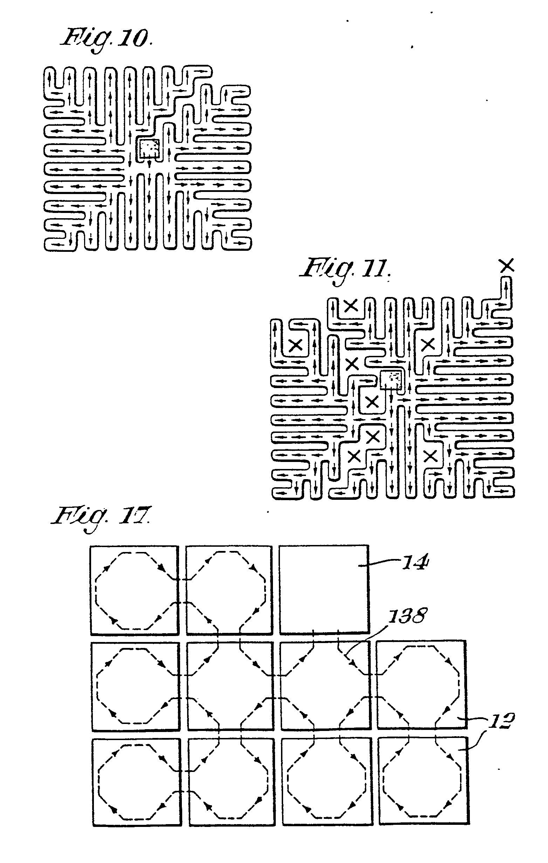

Figure 8 shows, in schematic form, the elements and intercouplings of the state machine 58.

The state machine 58 comprises a logic network 80 which is control and next state logic under the command of a three bit state counter 82. The state counter 82 and the logic element 80 together form a sequential logic state machine having eight main states designated Ø to 7 inclusively and six subsidiary states 0' to 5' inclusively. A command decoder 84 receives the clock signal from the clock line 36 and the common command signal from the function line 38 and decodes them in a manner explained below to provide a master reset signal MR, a first global signal G1 and a second global signal G2, all three used for the control of the state machine 58.

A two bit direction counter 86 provides a two binary digit, steering output to a selection gate 88. The selection gate, 88, in response to the output of the counter 86 steers the common command line 90 onto a selected one of the command lines 26N, 26E, 26S or 26W, steers the common connect line 92 onto a selected one of the connect lines 60N, 60E, 60S or 60W, and steers the common test line 94 onto a selected one of the test lines 68N, 68E, 68S or 68W. The direction counter 86 is incremented by a G1 signal when the state machine 58 is in state Ø and reset by the MR signal.

A 4 bit latch 96 receives the contents of the control registers 56WN, 56NE, 56ES and 56SW via the control couplings 66WN, 66NE, 66ES and 66SW and latches them, in response to a G2 signal, to the cross-over couplings 62N, 62E, 62S and 62W respectively, the latch 96 being reset with its outputs zero by a MR signal.

The logic element 80 receives and is responsive to the error indications on the error couplings 64N, 64E, 64S and 64W.

The logic element 80 is operable to set and reset, and respond to the states of a complete flip-flop 98, an active flip-flop 100 and a fault flip-flop 102. The selection gate 88 is also responsive to the state of the active flip-flop 100 in determining the direction in which to steer its input signals.

Power enters the state machine 58 via the power line 34. Power is permanently connected to the state machine 58. Power to all other elements in the cell 12 is regulated by a series switch 104 which is sensitive to excess current and switches off power to the rest of the cell 12 via the cell power line 106 in the event of excessive consumption. The switch 104 is also operable, in response to a switch command from the logic element 80 via the switch coupling 108, to selectably remove or supply power to the cell 12.

The state machine 58 responds to the global commands G1, G2 to test adjacent cells and incorporate them into a memory system should they prove working. Starting at the coupling port 14 the first cell 40 is tested by a controller whose details are given below, and if found good, is accepted into the system and itself becomes a tester for the next cell 12. The direction of test is rotated by 90° at each stage, so that the labyrinth of connected cells developes branches.

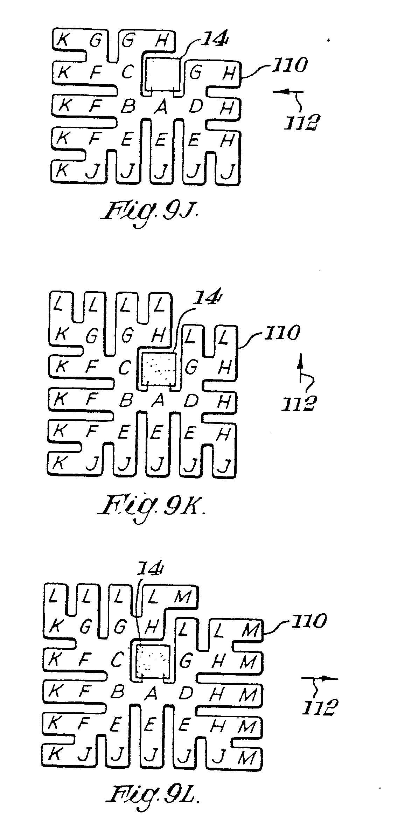

Figures 9A to 9L illustrate the action of the interconnect method on a perfect wafer 10 having no non-functional cells thereon. The direction of test is indicated by the arrow 112 next to the labyrinth 110. It is assumed that the interconnections to the outside world on the coupling port 14 are on its south side and that the rotation of direction follows the order SWNE repeatedly from Figure 9A to 9L. It is seen that the labyrinth grows at a rate which increases with size, and all cells are incorporated.

The controller 120 firstly tests in the south direction and incorporates a first cell A, as shown in Figure 9A. Having incorporated the first cell A the controller 120, as shown in Figure 9B, commands the first cell A to test in a westerly direction whereupon the first cell A incorporates by linking thereto, a second cell B. In Figure 9C the controller 120 commands the first and second cells A, B to test in a northerly direction. The first cell A tries to test the hole 14, but obtains no response. The second cell B picks up a third cell C. Figure 9D shows the controller 120 commanding the first, second and third cells A, B, C to test in an easterly direction. The third cell C tries to test the hole 14 but cannot do so. The second cell B is inhibited from testing the first cell A, because it has already undergone the test, but the first cell A picks up a fourth cell D. Figure 9E shows the controller 120 commanding all incorporated cells A, B, C, D to test in a southerly direction. The third cell C tries to but cannot test the second cell B as the second cell is already incorporated. The first, second and fourth cells each pick up one fifth cell E. Figure 9F shows the controller 120 commanding all of the incorporated cells A, B, C, D, E to test the adjacent cell in the westerly direction. The first, fourth and two of the fifth cells A, D and E are unable to pick up an adjacent cell as the cell adjacent thereto is already incorporated, but the second cell B, the third cell C and one of the fifth cells E each manage to pick up sixth cells F. Figure 9G shows all incorporated cells testing in a northerly direction and all cells free to do so picking up three sixth cells G. In Figures 9H to 9L all cells thus far incorporated at each stage test firstly in an esterly direction then in a southerly, westerly, northerly and again in an easterly direction respectively, incorporating seventh cells H, then eight cells J, ninth cells K, tenth cells L and eleventh cells M wherever the cell adjacent to another is free to be incorporated. This process may be continued until the entire wafer 10 is used up. Cells 16 at the edge of the tessellation obviously cannot link other than into the tessellation.

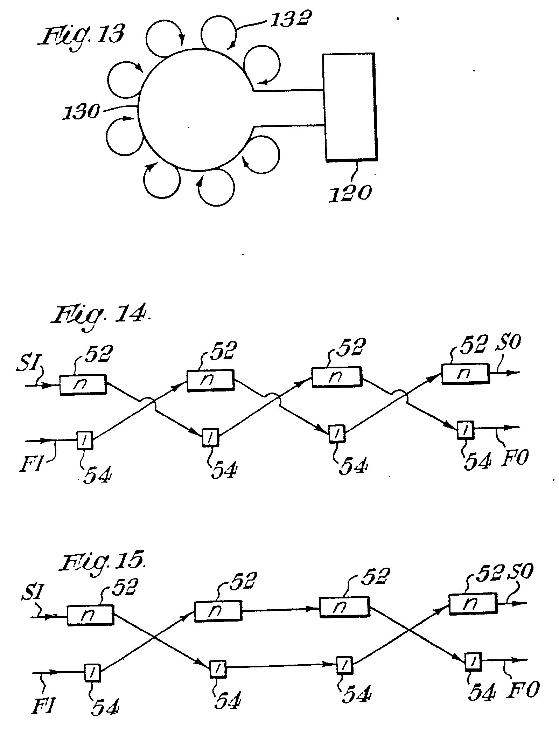

Figure 10 shows the labyrinth growth of Figure 9A to 9K taken to a total of 20 stages. The pattern of interconnection so obtained is apparent.

Figure 11 shows the result of a 20 stage growth cycle, executed in the same manner as the growth cycle of Figure 10, but on a wafer with defective cells which are rejected for incorporation and indicated by crosses. It is seen that all good cells around the defective cells are incorporated. That is not to say that patterns of defective cells do not exist which prohibit the incorporation of some working cells, but in general a very high percentage of working cells will be picked up.

The command decoder 84 generates the global signals G1, G2 and the master reset MR signal from the clock signal and the function signal in the manner indicated by table 1 below. It is to be appreciated that the clock signal is a 50% mark to space ratio repetitive clock of fixed period. The decoder 84 operates on the clock signal by means of gates and binary dividers to generate two separate 2-phase clock signals, C1 and C2 each of which comprises every alternate logically true portion of the clock signal, in a manner well known in the art. Such division leaves an indeterminacy as to which of the C1 and C2 signals occurs first. A method is therefore provided to rectify this deficiency, as shown in Table 1.

1=logically true     0=logically false

TABLE 1

| Function | Clock | Response |
|----------|-------|----------|
| 0 | 0 | No action |
| 0 | 1 | No action |
| 1 | 1 | If function went true immediately prior to C1 going true; then this indicates G1. If function went true immediately prior to C2 going true, then this indicates G2. |
| 1 | 0 | MASTER RESET (MR). To synchronise clock, take first clock after this to be C2. |

The state counter 82 operates in a simple Gray code. If the outputs of the counter 82 are indicated by A1, A2 and A3, then the counter operates as indicated in table 2 below.

TABLE 2

| A1 | A2 | A3 | State |
|----|----|----|-------|
| 0 | 0 | 0 | 0 |
| 0 | 0 | 1 | 1 |
| 0 | 1 | 1 | 2 |
| 0 | 1 | 0 | 3 |
| 1 | 1 | 0 | 4 |
| 1 | 1 | 1 | 5 |
| 1 | 0 | 1 | 6 |
| 1 | 0 | 0 | 7 |

7

# EP 0 172 311 B1

The direction counter 86 operates in the manner indicated by table 3 below. When ACTIVE 100 is set the particular cell is a tester and the test coupling 68 is activated in the appropriate direction. Otherwise, with ACTIVE 100 reset, the cell is subject to testing and connect coupling 60 is activated.

## TABLE 3

| Count | ACTIVE | ACTIVE |
|-------|--------|--------|
| 00 | SOUTH | NORTH |
| 01 | WEST | EAST |
| 11 | NORTH | SOUTH |
| 10 | EAST | WEST |

Figure 12 shows the manner of connection of the wafer 10 when employed as a memory.

The wafer 10 is coupled, via the pads of Figure 3 on the coupling port 14, to a controller 120. The controller 120 is operable to execute a test and grown sequence of commands to the wafer 10 and thereafter to supervise the deposition and retrieval of data in the now established and tested memory.

The controller 120 is mutually coupled to a host system, such as a data processor 122. The controller 120 provides indication to the host 122 when the memory has been tested and established enabling the host 122 to commence to use it. The size of the memory to be established is either defined by the host 122 signalling to the controller 120, or is a predetermined feature of the controller 120.

During the growth phase, the controller 120 issues the operational signals; the first Global signal, hereinafter referred to as G1, the second Global signal, hereinafter referred to as G2 and the Master reset signal, hereinafter referred to as MR to the wafer 10, coded on clock and function lines and between issuing signals runs in test patterns of fast data, slow data and control characters to test the overall memory loop for errors and in particular to test those cells 12 which are first being coupled into the overall circuit. The checking for errors takes place partly within the controller 120 and partly within the cells 12 themselves.

As far as the coupling port 14 is concerned, the controller 120 looks and behaves just like a cell 12 already incorporated into the circuit. The controller, when testing the first cell 40, behaves just as the first cell 40 behaves when testing a following cell 12, after the first cell 40 has been incorporated into the circuit.

During the growth phase, cells are distinguished by the state of the ACTIVE flip-flop 100, those cells 12 where it is set being tester cells and cells 12 where it is not set and adjacent in the direction of test to a tester cell being subject cells.

The controller 120 first issues the master reset signal MR to all cells 12 on the wafer, so resetting all counters and latches and putting the state machine 58 into state 0. This master reset (HR) is used only when testing the first cell 40, the state machine usually being set into state 0 by a G1 signal being applied when it is in state 7, as described below. The controller 120 then issues, with the state machine in state 0, a G1 signal, which has the effect of incrementing the direction counter 86 and setting the state machine 58 into state 1. The G1 signal is gated by the state machine 58 such that it reaches the direction counter 86 only when the state machine 58 is in state 0. The gated G1 signal is called the ROTATE signal. The effect of incrementing the direction counter is to swing the direction of test by ninety degrees.

Figure 13 shows the effect, in schematic form, of the action taken by the controller 120 while the state machine 58 is in state 1.

When in state 1 all tester cells 130 place the test signal on the test coupling 68N, 68E, 68S or 68W in the direction of test, and the signal on their command lines 26N, 26E, 26W or 26S, in the direction of test. The subject cells 132 may now be filled with data and control characters which they are not able to pass back into the tester cells 130. The controller 120 runs all ones into the control in pad 220, and knows when all of the subject cells 132 and the tester cells 130 are full when the all ones pattern reappears at the control out pad 300. Receipt of the command signal by the subject cell 132 causes its logic element 80 to switch on power to the registers and matrices 52, 54, 56, 50 via the switch 104.

The controller then issues a G2 signal to all of the cells 12, which has the effect of coupling all of the contents of control registers 56WN, 56NE, 56ES and 56SW, already filled with all ones, to the cross-over connections 62N, 62E, 62S and 62W respectively, and so setting all of the matrices 50N, 50E, 50S and 50W into the cross-over mode.

Figure 14 shows the situation achieved, in terms of fast and slow register 52, 54 interconnection, by this last operation.

Every cell 12 is in the condition indicated, whether it be a tester or a subject. The one bit long fast registers 54, hereinafter described without their former suffix, and the slow registers 52, hereinafter also described without their suffix, form two chains passing between the slow in SI line from the incoming matrix to the slow out line SO back to the incoming matrix, and between the fast in line FI from the incoming matrix to the fast out line FO back to the incoming matrix. If the slow registers are $n$ bits long, then the total length of each path is $2n+2$ bits. The controller 120 then administers identical patterns to the

8

fast in pad 200 and to the slow in pad 240, the patterns consisting of pseudo-random sequences each 2n+2 bits long so that the signal at SI is the same as the signal at SO and the signal at FI is the same as the signal at FO. The controller 120 does this until it sees the patterns returning and knows that it has filled the fast 54 and slow 52 registers.

Each state machine 58 watches the output of the input matrix error line 64N, 64S, 64E or 64W. It takes at least 2n+2 clock cycles before any match on any cell can be obtained. The error line 64N, 64S, 64E or 64W, hereinafter referred to without its suffix as 64, must show an initial fault indication, in response to which the logic element should set the fault flip-flop 102. If the fault flip-flop 102 is not set, the cell 12 is incapable of detecting errors and is therefore inhibited from passing into state 2 of the state machine 58 as it is incapable of testing neighbouring cells. The cell is frozen in state 1, in which frozen state the logic element 80 commands the switch 104 to remove power from the registers.

*All* cells, both testers and subjects change to the next stage on receipt of the appropriate global signals, provided no error condition has occurred during the present state else subjects then freeze.

The same fast and slow inputs and outputs are monitored by the error detection circuits in both tester and subject, if an error is indicated in a *tester* cell where ACTIVE 100 is set, then FAULT 102 will be set but the cell will *neither* freeze *nor* power down. If an error is indicated in a *subject* cell where ACTIVE 100 is reset, that cell will freeze *and* power down.

If, after the controller 120 has filled the registers 54, 52 the fault flip-flop 102 is set, and there is no output on the error line 64, the subject cell 132 is allowed to pass to further tests. If the fault flip-flop 102 is not set the subject cell 132 is incapable of acting as a tester and is therefore of no further use.

After filling the fast registers 54 and the slow registers 52 with the 2n+2 bit long pattern. The controller 120 issues a G1 signal which has the effect of sending all subject cells 132 where the fault flip-flop 102 is set into state 2 and powering down and freezing in state 1 all subject cells where the fault flip-flop 102 is not set. The act of passing into state 2 resets the fault flip-flop 102.

In state 2 the data integrity of the registers 52, 54 and cross-over switching function of the matrices 50 is tested. The controller 120 keeps the 2n+2 bit long data pattern circulating all the time. At least one data pattern is allowed to pass through each subject cell 132. The controller 120 then runs in a pattern of alternate 1s and 0s into the control register 56 and strobes the G2 signal to latch the matrices 50 into the connection configuration shown in Figure 15, the paths still being 2n+2 bits long. This action, since it maintains the paths at the same length, does not introduce an indication of error. Having allowed at least one 2n+2 bit long data pattern to pass through each subject cell 132, the controller then runs in a pattern of alternate 0s and 1s into the control registers 56 and issues another G2 signal to flip the connections of Figure 15, i.e. cross-over where straight through previously and vice versa, still maintaining a path length of 2N+2 bits and therefore not inducing an indication of error. Having allowed at least one complete data pattern to pass through each subject cell 132, the controller runs all zeros into the control registers 56 and issues a G1 signal, which has the effect of sending all subject cells where there has not been an error, i.e. where the fault flip-flop 102 is not set, into state 3, and powering down and freezing in state 2 any subject cell 132 where there has been an error, i.e. the fault flip-flop is set, on the grounds that there is a fault in the cross-over function of the matrices 50, the registers 52, 54 or both.

In state 3 the error line 64 is disabled by logic element 80 from setting fault F/F 102, and the complete flip-flop 98 is tested. The controller 120 issues a G2 command which latches the zeros of the control registers 56 to the matrices 50 and has the effect of setting the complete flip-flop 98 whose output is ignored by virtue of the state machine 58 being in state 3. The flip-flops 98, 100 should initially have been reset by the Master reset signal MR. The function of the complete flip-flop 98, is to inhibit all further testing and labyrinth growth (when set other than in state 3). The function of the Active F/F 100 is to make a good tested (subject) chip into a tester, in which condition it continues to test its neighbours until Complete is set. When Active is set, the chip does not respond to testing and connection signals. It is only necessary to test the complete flip-flop 98, since a failure of the active flip-flop 100 to reset on MR ensures that no testing will have taken place in the subject cell 132. In state 3 the controller, having set all of the matrices 50 into the straight through mode, so that the path length between the slow incoming line SI and the slow outgoing line SO is 4N bits long and the path length between the fast incoming line FI and the fast outgoing line FO is 4 bits long, runs 4 bit repeating patterns into the fast in pad 200 and 4N bit long repeating patterns into the slow in pad 240 until it knows that the registers 52, 54 are full by the reappearance of the 4N bit long patterns on the slow out pad 280. The controller then issues a G1 signal which has the effect of sending all subject cells 132 where the complete flip-flop 98 is set into state 4 and freezing, and powering down any subject cells 132 where the complete flip-flop 98 is not set.

The act of entering state 4 causes the complete flip-flop 98 to be reset and the error line 64 is enabled to set fault F/F 102.

The controller 120 keeps the wafer 10 in state 4 until a complete data pattern of 4N bits has passed through the slow registers 52. The controller 120 then applies a G1 signal which has the effect of sending all subject cells 132 which have not experienced a fault, i.e. wherein the fault flip-flop 102 is not set, into state 5, and freezing and powering down all subject cells 132 where the fault flip-flop is set.

In state 5 if the fault flip-flop 102 in a tester cell is reset such tester cells 130 continue to signal on their command lines 26 in the direction of the subject cells 132. The subject cells respond thereto by setting the CON F/F 51 in the appropriate direction selected by the connect command and the establish signal on connector 93.

The controller next issues a further G1 signal which has the effect of sending all newly tested cells into state 6 provided that the CON flip-flop 51 is set. If the CON flip-flop is not set the newly tested cell is frozen in state 5 and is powered down.

In state 6 tester cells 130 drop the signal on their command lines 26 and the newly tested subject cells 132 raise a signal on their command lines 26 in the direction of the tester cells 130. The controller 120 then applies the G1 signal to take all cells into state 7. In response to this, the tester cells 130 apply the establish signal on connector 93 which, in conjunction with the test command signal 68 sets the CON F/F 51 in the direction towards the subject cells 132 to confirm the connection established in the subject cells in state 5, provided that the Fault F/F's 102 in the tester cells are not set, and also provided that the said subject cells have raised the required signal on their command lines 26 in state 6. In state 7 those fully tested subject cells 132, having the CON F/F 51 set, now set the Active F/F 100 becoming in turn tester cells 130 ready for the next cycle of growth. All cells drop all signals on command lines 26 in state 7 and the controller 120 sends data into the slow registers 52 and waits for its return to measure the length of the memory achieved at the end of each growth phase.

If in state 6 the subject does not raise the command signal (because CON is not set or some other fault) the tester will not establish a connection in state 7 and the subject will be ignored (although powered up). Also in state 7 the tester may fail to set its CON F/F for some reason. Neither of these faults will affect the established labyrinth—the worst that can happen is that the (disconnected) subject becomes ACTIVE and starts to build its own separate labyrinth—this just wastes memory.

The controller 120 then applies yet another G1 signal to send the state machine 58 back to state 0. The controller 120 makes the decision if further growth is required. If further growth is required, a G1 signal is applied to the wafer 10 and it continues on a new cycle in the growth phase. If no further growth is required, the controller 120 sets the complete flip-flop 98 in every single cell 12 on the wafer 10, and thus inhibits all further testing and growth, by sending a G2 signal while state machines 58 are in state 0. The controller 120 then signals to the host 122 that the memory that has been established is adequate and changes to an operational mode for servicing the data access of the memory in response to host commands.

It may be that the controller 120 has been unable to find a large enough memory space to satisfy the needs of the host 122. In this case the controller 120 may scrap the established memory by issuing the master reset MR signal and starting again from another edge of coupling port 14. Repeated failure will result in shutdown.

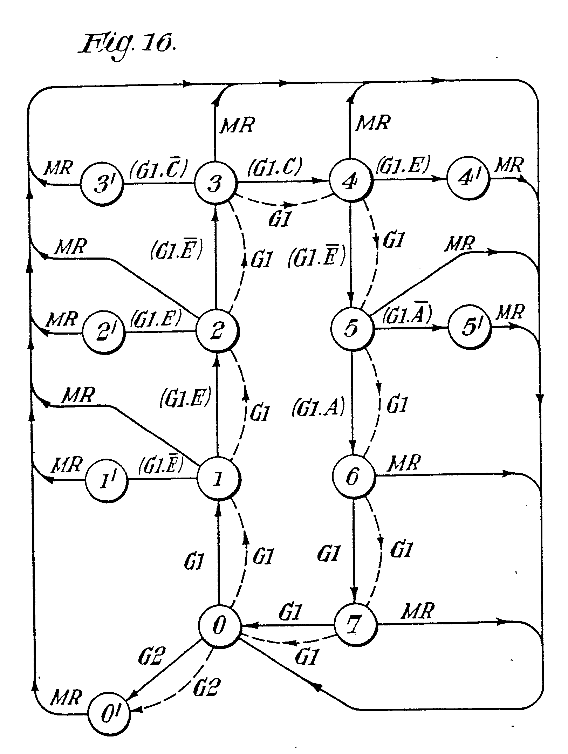

The operation of the state machine 58 is shown and further described by the state diagram of Figure 16. The transitions of the state machine 58 when in a subject cell 132 are indicated by solid line, and when in a tester cell 130 are shown by dotted line. Table 4 given hereinafter lists and explains the symbols used in Figure 16. Eight main states 0 to 7 are shown, corresponding to the three bit count of the state counter 82. Five default states 1' to 5' are entered and maintained in the event of a functional test being failed in any of main states 1 to 5 respectively. The termination of growth state 0' is entered from state 0 by the controller 120 issuing a G2 signal instead of a G1 signal, whereafter the incorporated cells 12 are used as a data store for the host 122.

Table 5 summarises the actions of the state machine 58 in a subject cell 132 as the state machine 58 moves between the states indicated in Figure 16. Table 6 summarises the actions of the state machine 58 in a subject cell 132 in each of the states of Figure 16. Table 7 summarises the actions of the state machine 58 in a tester cell 130 as the state machine moves between the states allowed to it in Figure 16, and Table 8 summarises its actions when in those states. Table 9 summarises the actions of the controller 120 taken when the state machine 58 is in each state to test the data transfer properties of each cell 12 and to cycle the state machine 58 between states. The controller 120 has no direct feedback indicative of the state that any of the state machines 58 are in, but assumes that the state machines 58 respond to its sequence of input signals G1, G2, MR.

TABLE 4
Definitions of symbols used in Figure 16

G1=First Global Signal
G2=Second Global Signal
E=An error has been detected by the checking logic in the Matrix 50, and the fault flip flop 102 is therefore set.
$\bar{E}$=No error has been detected by the checking logic in the Matrix 50 and the fault flip flop 102 is therefore not set.
MR=Master Reset signal
C=Complete flip flop 98 is set
$\bar{C}$=Complete flip flop 98 is not set
N=CON flip flop 51 is set
$\bar{N}$=CON flip flop 51 is not set

TABLE 5

Actions of the state machine 58 in subject cell 132 in transitions between states

| Transition | Action |
|---|---|
| 0 to 1 | Increment Direction Counter 86 |
| 1 to 2 | Reset Fault flip flop 102 |
| 2 to 3 | Set complete flip flop 98 |
| 3 to 4 | Reset complete flip flop 98 |
| 4 to 5 | NIL |
| 5 to 6 | NIL |
| 6 to 7 | NIL |
| 7 to 0 | NIL |
| 1 to 1' | NIL |
| 2 to 2' | NIL |
| 3 to 3' | NIL |
| 4 to 4' | NIL |
| ANY to 0 (MR) | Reset all counters and flip flops Remove power from registers etc. |

TABLE 6

Actions of the state machine 58 in subject cell 132 in each state

| State | Action |
|---|---|
| 0 | NIL |
| 1 | Switch on power to registers and matrices when signal received from tester on command line 26. Set fault flip flop 102 if data error detected. Raise signal on connect coupling 60. |
| 2 | Set fault flip flop 102 if data error detected |
| 3 | Inhibit setting of fault flip-flop 102 |
| 4 | Set fault flip flop 102 if data error detected |
| 5 | Set CON F/F 51 |
| 6 | Raise command line 26 to tester |
| 7 | Set active flip-flop 100 Drop command line to tester |
| 1' | Remove power from registers etc. freeze |
| 2' | Remove power from registers etc. freeze |
| 3' | Remove power from registers etc. freeze |
| 4' | Remove power from registers etc. freeze |
| 5' | Remove power from registers etc. freeze |
| 0' | Not applicable, this state never entered by subject cell |

### TABLE 7
Actions of the state machine 58 in a tester cell 130 in transitions between
its allowed states

| Transition | Action |
|---|---|
| 0 to 1 | Increment direction counter 86 |
| 1 to 2 | Reset fault flip-flop 102 |
| 2 to 3 | |
| 3 to 4 | |
| 4 to 5 | ........NO ACTION |
| 5 to 6 | |
| 6 to 7 | |
| 7 to 0 | |
| ANY to 0 (MR) | Reset all counters and flip flops |

### TABLE 8
Actions of the state machine 58 in a tester cell 130 in each of
its allowed states

| State | Action |
|---|---|
| 0 | NIL |
| 1 | Apply test signal on test couplings 68<br>Raise signal on command line 26 |
| 2 | Set fault flip-flop 102 if data error detected |
| 3 | Inhibit setting of fault flip-flop 102 |
| 4 | Set fault flip-flop 102 if data error detected |
| 5 | NIL |
| 6 | Drop command signal on command line 26 |
| 7 | Set CON F/F 51 |
| 1' to 5' | Not applicable, these states never entered |
| 0' | Set complete flip-flop 98 |

TABLE 9
Actions of controller 120 when the state machine 58 is in each state

| State | Action |
|---|---|
| 0 | Issue G1 signal if growth is to continue, otherwise issue G2 signal to terminate growth. |
| 1 | Fill control registers 56 with all 1's then issue G2 signal, thereafter fill data registers with 2n+2 bit long patterns. Lastly issue G1 signal. |
| 2 | Keep data pattern of state 1 circulating all the time. Allow one full pattern to pass, then run alternate 0's and 1's into control registers and issue G2 signal. Allow one further pattern to pass then run alternate 1's and 0's into control registers and issue G2 signal. Thereafter, run all 0's into control registers and issue G1 signal. |
| 3 | Issue G2 signal. Run 4n bit long pattern into slow registers and 4 bit long pattern into fast registers. Issue G1 signal. |
| 4 | Allow passage of at least 4n bits into and out of slow registers. Issue G1 signal. |
| 5 | Issue G1 signal |
| 6 | Issue G1 signal |
| 7 | Send data pattern around slow registers to measure length of memory achieved, then issue G1 signal. |
| 0' | Act as interface to host. |

(N.B.) the states 1' to 5' are not relevant to the actions of the controller 120 as they are entered autonomously by subject cells under fault conditions, such states never being apparent to controller 120.

The invention has so far been described with reference to having connections to the controller 120 on one edge only of the coupling port 14. It is advantageous to employ connections to two, three or four edges on the coupling port 14 so that the controller 120, when faced with a failure to establish a sufficiently large memory, may try again by starting at an alternative face.

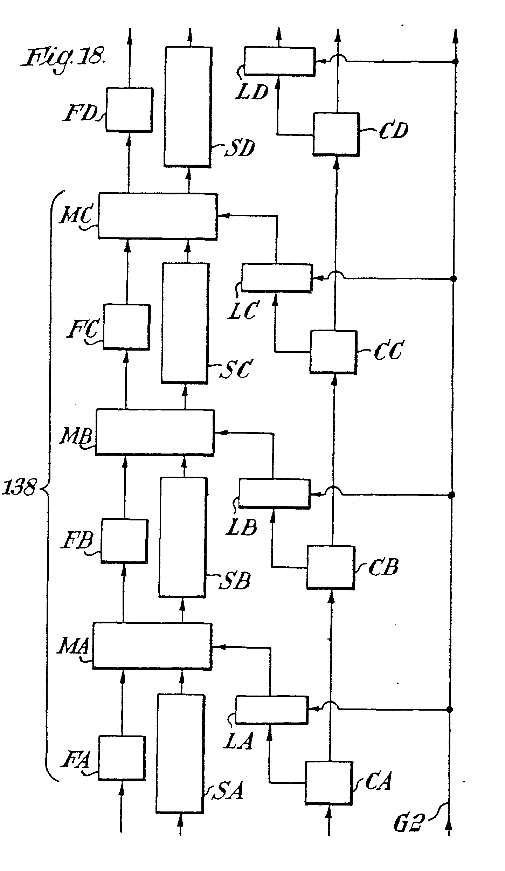

Figure 17 shows the layout, in physical terms, of the memory established by the controller 120, when the memory is finalised in a state corresponding to the growth point indicated in Figure 9F.

The data path 138 wends a labyrinthine route between the cells 12 starting at and ending at the coupling port 14. The same is true no matter what the size of the established memory. The data path 138 comprises a fast data path consisting of the fast registers 54 connected in series, a slow data path consisting of the slow shift registers 52 connected in series, and a control path, consisting of the control registers 56 connected in series, all three paths running in parallel and all series connections being established through the matrices 50. It is to be noted that the path 138, topologically speaking, may be represented as a single loop.

Figure 18 shows a portion of the data path 138 stretched out into the topologically equivalent straight line. The chain of fast registers FA, FB, FC, FD are the one bit long fast shift registers 54WN, 54NE, 54ES, 54SW of Figure 4, but, as will be appreciated from Figure 17, the actual coupling need not be in any particular order. The chain of slow registers SA, SB, SC, SD, are the N-bit long shift registers 52WN, 52NE, 52ES and 52SW of Figure 4. Once again, they need not be in any particular order and sequential members in the chain may be on adjacent cells 12. The chain of 1 bit long control shift registers CA, CB, CC and CD are the control registers 56WN, 56NE, 56ES and 56SW of Figure 4. Yet again, they need not be in any particular order and sequential members of the chain may be in adjacent cells 12. The cross-over matrices MA, MB, MC and MD are part of the switching matrices 50N, 50E, 50S and 50W and they too are subject to the same indeterminacy of order. The latches LA, LB, LC and LD are individual elements in the 4 bit latch 96 of Figure 8 and are operable, in response to the second global signal G2, to latch the state of the control registers CA, CB, CC and CD to the matrices MA, MB, MC and MD, which respond to a latched logical 1 signal by going into the cross-over mode and in response to a latched logical 0 signal go into the straight through mode. The individual registers are physically associated, with the elements FA, SA, MA, LA, and CA being in the same quadrant of the same cell 12, FB, SB, MB, LB and CB being similarly associated, as are FD, SD, MD, LD and CD and FC, SC, MC, LC and CC.

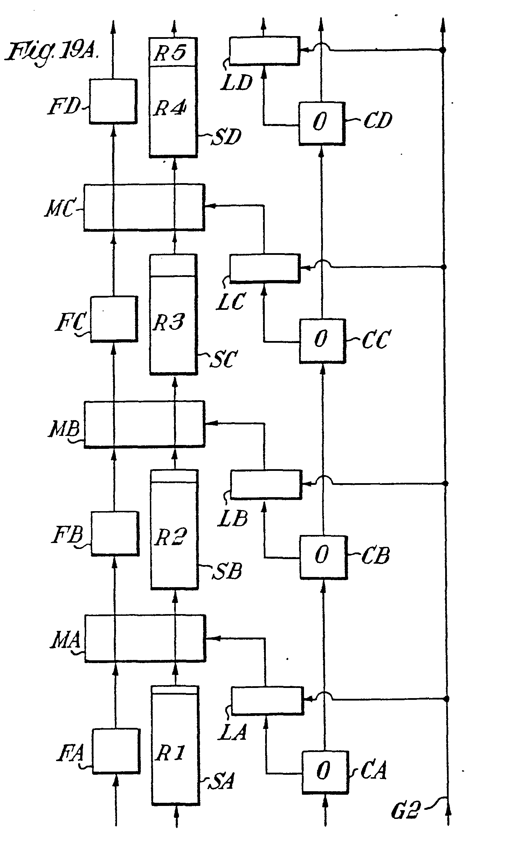

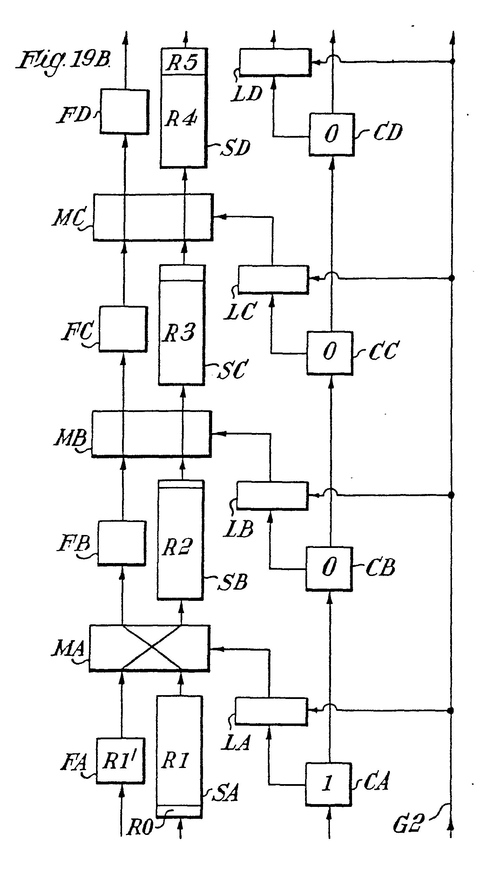

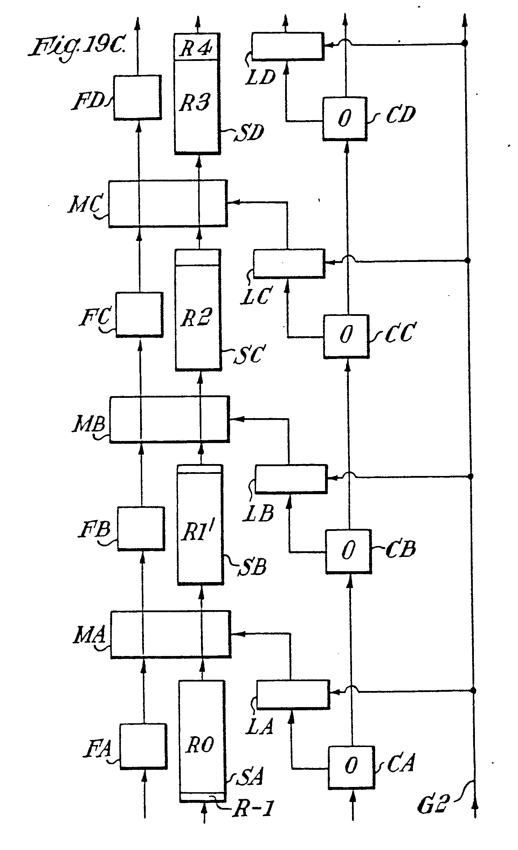

Figure 19A shows the addressing of a record in the chain 138.

The slow registers SA, SB, SC and SD are shown as containing between them, all of four data records R1, R2, R3 and R4 and part of a fifth data record R5. The records R1, R2, R3, R4 and R5 are each 1 bit shorter than the slow registers SA, SB, SC and SD. The first register SA contains all of the first record R1 and one bit of the second record R2. The second slow register S2 contains all but one bit of the second record R2 and two bits of the third record R3. The third slow register SC contains all but 2 bits of the third record R2 and three bits of the fourth record R3. The fourth slow register SD contains all but 3 bits of the fourth record R4, and four bits of the fifth record R5. This one-bit-at-a-time overspill continues up the chain 138. In general, if the slow registers SA, SB, SC, SD are each N bits long, it will take a maximum of N clock cycles to bring any particular record into a position to be accessed. In this example, the first record R1 is to be accessed. The controller 120 has been filling the control line with zeros prior to the first record R1 reaching the first matrix MA. All of the matrices MA, MB, MC and MD are in the straight through position.

Figure 19B shows the situation at the next clock pulse.

The controller 120 has previously calculated the number of clock pulses required before the first record R1 reaches the end of a slow register SA, SB, SC or SD and has, at the appropriate moment, fed a "1" into the control register chain such that it reaches the control register, in this case the first control register CA, at the same time as the beginning of the first record R1 reaches the output of the corresponding slow register SA. The controller 120 has been keeping track of all of the records by clock pulse counting as they shift along the chain 138, and feeding the records back into the beginning of the chain 138 as they fall out of the end of the chain 138 at the coupling port 14. The controller 120 selects, as the slow register from which to access a particular record, that slow register, in this example the first slow register SA, the output of which the particular record, in this case the first record R1, will reach in the minimum number of clock pulses. The controller 120 has, at the same time that it started sending the 1 into the control registers chain, started sending a serial bit representation of a replacement record R1' into the chain of fast registers such that the first bit of the replacement record R1' reaches the first fast register FA at the same instant that the 1 reaches the first control register CA and the beginning of the first record R1 reaches the output of the first slow register SA. A succeeding record, RO, has begun to enter the first slow register SA. All records R1, R2, R3, R4, R5, R0 has moved up one bit place. The controller 120, having positioned the first record R1 at the output of the first slow register SA, the 1 on the control register C1 and the first bit of the replacement record R1' on the first fast register F1, then applies a second global signal G2 which has the effect of latching a zero into all matrices save the first matrix MA, which, being in receipt of a latched 1, changes to the cross-over mode.

In the cross-over mode, the first matrix MA sends the first record R1 into the second fast register FB and the output of the first fast register FA into the second slow register SB. The first record R1 is thus sent, one bit for every successive clock pulse, into the fast chain, and thereon, at speed, to the coupling port 14, where it is extracted by the controller 120 for transmission to the host 122 if required, and the replacement record R1' is sent into the slow chain in place of the first record R1.

Figure 19C shows the situation N clock pulses after the commencement of access.

The controller 120 has counted clock pulses and, N–1 clock pulses after the commencement of the data exchange, that is, just after the last bit of the first record R1 has passed out of the first slow register SA, has issued another second global signal G2. Since the control chain is filled with zeros the first latch LA latches a zero to the first matrix MA which is thereby set back into the straight through mode. The last bit of record R1 is then in fast register FB, the next-to-last bit in fast register FC, etc.

This completes the deposition and retrieval process for the first record R1. The controller 120 uses the same technique when accessing any other record.

It will be apparent that this simple method is inadequate to deal with the situation where the 1 in the control chain is still in the control chain when the end-of-record second global signal G2 is sent. It will be apparent that simple data replacement techniques and various manipulations of the control character on the control chain may overcome this problem. It is also possible to arrange that the number of bits in a record, N–1, is more than the maximum number of registers SA, SB, SC, SD etc. permissible in the chain 138, and to arrange that the controller 120 does not access a further record until it sees the 1 on the control chain returning to the coupling port 14. It will also be apparent that the controller 120, by manipulating the start-of-record and the end-of-record global signal G2, in conjunction with appropriate bit patterns in the control register chain, may read in and out an indefinitely and selectably long string of data, being many records, portions of records, and even portions contained within a record.

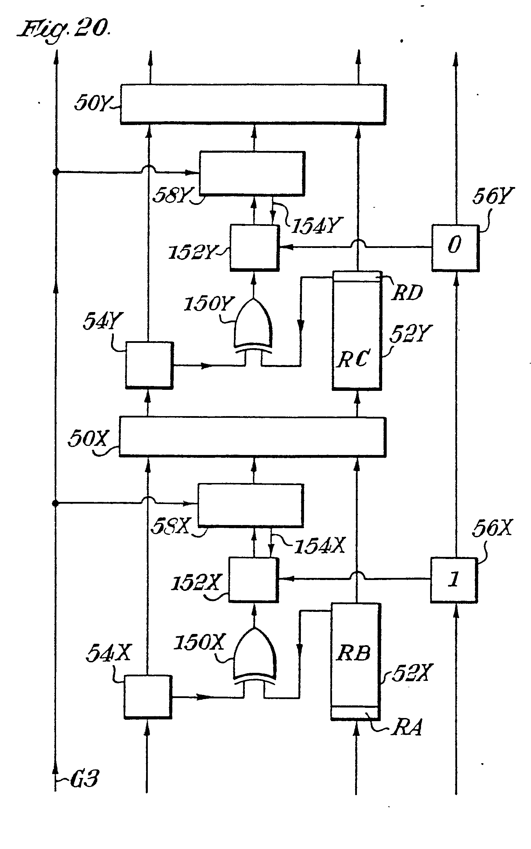

Figure 20 shows how, by the addition of a data comparison facility between the fast and slow chains of Figure 18, the memory is made both random access and content addressable.

With all cells 12 in state 0' (COMPLETE 98 set) global signal G2 is used, in conjunction with 1's on the control register chain, to set switches 50 to cross-over mode. In state 0', global signal G1 can be used to place all cells in content addressable mode (state 0'') in which state suitable signals on the control line can

14

be used to set switches to cross-over mode when appropriate. Global signal G1 is used to return all cells to state 0' (random access) from state 0'' when required.

The state machines 58X, 58Y in two consecutive members of the chain 138 are modified over those previously described to generate an enabling signal in response to the first global signal G1. Comparison gates 150X, 150Y compare the contents of the fast register 54X, 54Y with the first bit in the slow register 52X, 52Y. The comparison gate 150X, 150Y gives a logically true signal at its output if there is a difference between its inputs.

The output of the comparison gate 150X, 150Y is coupled as a conditional reset input to a data selection flip-flop 152X, 152Y. The data selection flip-flop 152X, 152Y is also responsive to the initiating signal from the state machine 58X, 58Y on the initiating coupling 156X, 156Y and the enabling signal from the state machine 58X, 58Y on the enabling coupling 154X, 154Y. The flip-flop 152X, 152Y is set by the initiating signal from the state machine 58X, 58Y becoming logically true, and is reset whenever the enabling signal from the state machine 58X, 58Y is logically true and the comparison gate 150X, 150Y sees a data mismatch. The flip-flop 152X, 152Y stays reset or set despite data mismatches if the enabling signal becomes false.

On entering the content-addressable state (after G1 signal) flip-flop 152 is reset and the state machine 58 is responsive to *pairs* of bits on the control line i.e. the bit currently in register 56 and the immediately following bit (seen as the input 56). When 56 contains a '1' and the following bit is '0', initiating line 156 is raised to set flip-flop 152 (and dropped on the following clock cycle) and enabling line 154 is also raised to enable data/key comparison to be made by gate 150. A subsequent '10' bit pattern on the control line will reset the enabling line 154, disabling data comparisons so that mismatches have no effect on flip-flop 152. Data comparison is again enabled by another '10' bit pattern, so providing a masking function. At any time subsequent to the first, initiating '10' pattern, a '11' bit pattern on the control line will cause the state machine 58 to set the matrix 50 to the cross-over mode if, and only if, the flip-flop 152 is set. The timing of the '11' bit pattern by the controller 120 is such that the desired matched record, or part thereof, is correctly provided as output onto the fast line 54. A subsequent '11' pattern returns all matrices 50 to straight-through mode and resets all flip-flops 152 ready for another comparison sequence.

The data records RA, RB, RC, RD as shown in Figure 20 are still one bit shorter than the slow registers 52X, 52Y.

The controller 120 runs a literal, a serial data word, which is to be matched against the data in the slow registers 52X, 52Y and so on, as a key match, into the fast line in synchronism with a mask sequence of pairs of 1s and 0s into the control line. Whenever a 10 pair reaches the control register 56X, 56Y the data comparison is alternately enabled and disabled.

To illustrate access by content addressing, Figure 20 shows the first bit of record RA entering slow register 52X, record RB occupying the remainder of slow register 52X, and slow register 52Y containing record RC and the last bit of record RD. The literal, or key, to be matched against the data records is input to the fast registers, with its first bit in register 54X currently being compared with the first bit of record RA. The control register 56X contains a '1' with the following bit (the input to 56X) being a '0', causing flip-flop 152X to be set by initiating signal 156X and enabled by line 154X. If the key and record comparison shows a match (logically false output from gate 150X) flip-flop 152X remains set.

At the next clock cycle the second bit of record RA enters slow register 52X and the first bit of record RB enters slow register 52Y. The first bit of the comparison literal moves on to fast register 54Y and is compared with the first bit of record RB via gate 150Y. Flip-flop 152Y is set and enabled by the '1' now in control register 56Y and the '0' in control register 56X. If there is a mismatch between the literal and RB, flip-flop 152Y will be reset, otherwise it will remain set. Within this same clock period the second bit of the literal in fast register 54X is compared with the second bit of record RA and flip-flop 152X either remains set if the bits match, or is reset by a mismatch. The comparison process can be disabled at any time by the propagation of a '10' bit pair along the control line, and subsequently re-enabled by another '10' bit pair, allowing selected fields of the comparison literal to be masked.

During subsequent clock periods the data records and the comparison literal continue to move along the slow and fast lines, respectively, with the result that the literal is compared bit-by-bit with each and every data record (subject to any required masking) in the time taken for the literal to completely traverse the length of the fast line.

When the comparison process is complete i.e. when the last bit of the literal has been matched against the last bit of record RA, the latter having just entered slow register 52X, the bit pair '11' is placed on the control line, control register 56X containing a '1' and having its input also a '1'. If flip-flop 152X is still set, indicating that record RA matched the non-masked parts of the literal, this control command causes state machine 58X to set matrix 50X to cross-over mode at the next clock cycle. At this time the first bit of record RA reaches the end of slow register 52X and record RA is subsequently output to the fast line. Whether record RA matched the literal or not, the '11' bit pair propagates along the control line ready to set a matrix to cross-over mode wherever a data match is indicated and synchronised to the arrival of the first bit of the matched record at the end of the appropriate slow register. Assuming that record RA matched and is output, when the last bit of RA is transferred to the fast line another '11' bit pair on the control line resets all flip-flops 152 unconditionally, ready for another comparison and data output sequence.

When several data records in the slow registers 52 match the comparison literal so that several

# EP 0 172 311 B1

flip-flops 152 are set, the '11' control command will cause several matrices 50 to be set along data path 138 in the appropriate clock cycles. The overall result is that the matched record furthest along data path 138 is output from the end of the fast line, and the record next furthest along data path 138 moves along the fast line then back on to the slow line to take the place of the output record. Other matched records move similarly to advance their positions along the slow line. Repeating the comparison process with the same literal will output the set of 'matched' records one by one.

It will be apparent to those skilled in the art that the cells 12 need not necessarily be square. The cells may be of any shape, which provides a tessellation and provided with coupling on every edge. It will also be apparent that the cells 12 may be adapted to comprise data processing elements of any kind. When the cells are used as a memory, many wafers 10 may be provided accessed together to provide a parallel data word memory. There can be more than one coupling port 14. The wafer 10 may have coupling means provided at its edges. The state machine 58, which normally receives power at all times, may have its power supply made conditional upon the raising of the signal on the command line 26, by an adjacent tester cell 130. Many data chains 138 may be provided on one wafer 10 by growth from more than one port 14 or edge coupling means. A wafer may be divided into several, mutually exclusive areas of cells 12, each area accessed from its own port 14.

## Claims

1. An integrated circuit (10) comprising a data storage element (52, 54, 56, 50) including: a data storage shift register (52), a data access shift register (54), a cross-over switch (50) for crossing-over the outputs of said data storage shift register (52) and said data access shift register (54), and a data comparator (150, 152, 58) for performing a comparison operation between the first bit in said data storage shift register (52) and the output of said data access shift register (54), said data comparator (150, 152, 58) being operable to provide an output indicative of a mismatch having occurred therebetween during the course of said operation, said integrated circuit (10) being characterised by said data storage element (52, 54, 56, 50, 150, 152) comprising a control character shift register (56); by said data comparator (150, 152, 58) being operable in response to the first presentation of a first control character ("10") to said control character shift register (56) to commence said comparison operation; by said data comparator (150, 152, 58) being operable in response to subsequent presentations of said first control character ("10") to said control character shift register (56) alternately to suspend and to resume said comparison operation; by said cross-over switch (50) being operable in response to the first presentation of a second control character ("11") to said control character shift register (56) to commence said crossing-over if and only if said data comparator (150, 152, 58) does not provide said output indicative of a mismatch, and wherein said cross-over switch (50) is operable to abandon said crossing-over in response to the subsequent representation of said second control character (11) to said control character shift register (56).

2. An integrated circuit (10) according to Claim 1, comprising a plurality of said data storage elements (52, 54, 56, 50, 150, 152, 58), each element being connected for use concatenated with a preceding data storage element (52, 54, 56, 50, 150, 152, 58) and a subsequent data storage element (52, 54, 56, 50, 150, 152, 58) where said control character shift register (56) is operable to receive said control characters from the control character shift register (56) of said preceding data storage element (52, 54, 56, 50, 150, 152, 58) and to pass on said control characters to the control character shift register (56) in said subsequent data storage element (52, 54, 56, 50, 150, 152, 58), where said data storage shift register (52) is operable to receive input data from the data storage shift register (52) in said preceding data storage element (52, 54, 56, 50, 150, 152, 58) when the cross-over switch (50) in said preceding data storage element (52, 54, 56, 50, 150, 152, 58) is not in the act of performing a crossing-over and to receive input data from the data access shift register (54) in said preceding data storage element (52, 54, 56, 50, 150, 152, 58) when the cross-over switch (50) in said preceding data storage element (52, 54, 56, 50, 150, 152, 58) is in the act of performing a crossing-over; where said data storage shift register (52) is operable to provide output data as input to the data storage shift register (52) in said subsequent data storage element (52, 54, 56, 50, 150, 152, 58) when said cross-over switch (50) is not in the act of performing a crossing-over and to provide output data as input to the data access shift register (54) in said subsequent data storage element (52, 54, 56, 50, 150, 152, 58) when said cross-over switch (50) is in the act of performing a crossing-over; where said data access shift register (54) is operable to receive input data from the data access shift register (54) of said preceding data storage element (52, 54, 56, 50, 150, 152, 58) when the cross-over switch (50) in said preceding data storage element (52, 54, 56, 50, 150, 152, 58) is not in the act of performing a crossing-over and to receive input data from the data storage shift register (52) in said preceding data storage element (52, 54, 56, 50, 150, 152, 58) when the cross-over switch (50) in said preceding data storage element (52, 54, 56, 50, 150, 152, 58) is in the act of performing a crossing-over; and where said data access shift register (54) is operable to provide output data as input to the data access shift register (54) in said subsequent data storage element (52, 54, 56, 50, 150, 152, 58) when said cross-over switch (50) is not in the act of performing a crossing-over and to provide output data as input to the data storage shift register (52) in said subsequent data storage element (52, 54, 56, 50, 150, 152, 58) when said cross-over switch (50) is in the act of performing a crossing-over.

3. An integrated circuit (10) according to Claim 2, comprising an array of data storage cells (12, 16)

## EP 0 172 311 B1

wherein each of said cells (12, 16) comprises a plurality of said data storage elements (52, 54, 56, 50, 150, 152, 58) and wherein said cross-over switch (50) comprises coupling logic (50) selectably operable to select said subsequent data storage element (52, 54, 56, 50, 150, 152, 58) either from within the same cell (12, 16) or from a contiguously adjacent cell (12, 16).

4. An integrated circuit (10) according to Claim 3, wherein each of said cells (12, 16) comprises a state machine (58), coupled to operate said coupling logic (50) and to receive a global signal (36, 38), and an initiating signal (26) from a neighbouring cell (12, 16), and wherein said coupling logic (50) comprises data comparison means (72, 74, 76) for comparing the data passing in and out of the shift registers (52, 54) associated therewith and providing indication (on 64) of equality or inequality to said state machine (58), where, in response to the receipt of said global signal (on 36, 38) and of said initiating signal (on 26) from said neighbouring cell (12, 16), said state machine (58) is operable to perform a functional test on said cell (12, 16) to determine if said cell is functional.

5. An integrated circuit (10) according to Claim 4, wherein said state machine (58) is operable such that any previously untested cell (12, 16) is operable to undergo said functional test and to functionally couple (by 52) to said neighbouring cell (12, 16) if said test is passed, such that any cell (12, 16) which has passed said test is capable of providing said initiating signal (on 26) to a plurality of other neighbouring cells (12, 16), and such that each time it receives said global signal (on 36, 38) said state machine (58) selects (using 86) one of said other neighbouring cells (12, 16) for provision thereto of said initiating signal (on 26), at least one of said cells (12, 16) in said array being provided with means for receiving said initiating signal from and functionally coupling to an input port (14).

6. An integrated circuit according to Claim 4, wherein each cell (12, 16) in said array of cells (12, 16) comprises four data storage elements (52), and wherein each cell (12, 16) in said array has a maximum number of four neighbouring cells (12, 16).

7. An integrated circuit according to Claim 6, wherein said state machine (58) comprises direction counting means (86) incremental in response to each receipt of said global signal (on 38, 36) to select each of said neighbouring cells (12, 16) in turn for the provision thereto of said initiating signal (on 26).

**Patentansprüche**

1. Integrierte Schaltung (10) mit einem Datenspeicherelement (52, 54, 56, 50), das folgende Komponenten enthält:
ein Datenspeicher-Schieberegister (52), ein Datenzugriffs-Schieberegister (54), einen Kreuzungsschalter (50) zum Überkreuzschalten des Ausgänge des Datenspeicher-Schieberegisters (52) und des Datenzugriffs-Schieberegisters (54), und einen Datenkomparator (150, 152, 58) zum Durchführen von Vergleichen zwischen dem ersten Bit in dem Datenspeicher-Schieberegister (52) und dem Ausgang des Datenzugriffs-Schieberegisters (54), wobei der Datenkomparator (150, 152, 58) ein Ausgangssignal abgibt, wenn eine Abweichung während des Vergleichs aufgetreten ist;
dadurch gekennzeichnet, daß
das Datenspeicherelement (52, 54, 56, 50, 150, 152) ein Steuerzeichen-Schieberegister (56) aufweist;
daß der Datenkomparator (150, 152, 58) beim ersten Zuführen eines ersten Steuerzeichens ("10") an das Steuerzeichen-Schieberegister (56) anspricht, um den Vergleich zu beginnen;
daß der Datenkomparator (150, 152, 58) beim nachfolgenden Zuführen des ersten Steuerzeichens ("10") an das Steuerzeichen-Schieberegister (56) abwechselnd den Vergleich aufhält und wieder aufnimmt;
daß der Kreuzungsschalter (50) beim ersten Zuführen eines zweiten Steuerzeichens ("11") an das Steuerzeichen-Schieberegister (56) das Überkreuzschalten beginnt, wenn der Datenkomparator (150, 152, 58) kein, eine Abweichung anzeigendes, Ausgangssignal abgibt;
und daß der Kreuzungsschalter (50) das Überkreuzschalten beim nachfolgenden Zuführen des zweiten Steuerzeichens ("11") an das Steuerzeichen-Schieberegister (56) aufgibt.

2. Integrierte Schaltung (10) nach Anspruch 1, dadurch gekennzeichnet,
daß eine Mehrzahl solcher Datenspeicherelemente (52, 54, 56, 50, 150, 152, 58) vorgesehen ist, die in Kaskade geschaltet sind;
daß jeweils einem Steuerzeichen-Schieberegister (56) die Steuerzeichen des Steuerzeichen-Schieberegisters (56) des vorhergehenden Datenspeicherelements (52, 54, 56, 50, 150, 152, 58) zugeführt und diese Steuerzeichen an das Steuerzeichen-Schieberegister (56) das nachfolgenden Datenspeicherelements (52, 54, 56, 50, 150, 152, 58) weitergegeben werden;
daß jeweils einem Datenspeicher-Schieberegister (52) die Eingangsdaten des Datenspeicher-Schieberegisters (52) des vorhergehenden Datenspeicherelements (52, 54, 56, 50, 150, 152, 58) zugeführt werden, wenn der Kreuzungsschalter (50) des vorhergehenden Datenspeicherelements (52, 54, 56, 50, 150, 152, 58) nicht überkreuz geschaltet ist und die Eingangsdaten von dem Datenzugriffs-Schieberegister (54) des vorhergehenden Datenspeicherelements (52, 54, 56, 50, 150, 152, 58) empfängt, wenn der Kreuzungsschalter (50) des vorhergehenden Datenspeicherelements (52, 54, 56, 50, 150, 152, 58) überkreuz geschaltet ist;
daß jeweils ein Datenspeicher-Schieberegister (52) Ausgangsdaten als Eingangssignal an das Datenspeicher-Schieberegister (52) des nachfolgenden Datenspeicherelements (52, 54, 56, 50, 150, 152, 58)

17

EP 0 172 311 B1

liefert, wenn der Kreuzungsschalter (50) nicht überkreuz geschaltet ist und Ausgangsdaten als Eingangsdaten an das Datenzugriffs-Schieberegister (54) des nachfolgenden Datenspeicherelements (52, 54, 56, 50, 150, 152, 58) liefert, wenn der Kreuzungsschalter (50) überkreuz geschaltet ist;

daß dem Datenzugriffs-Schieberegister (54) Eingangsdaten von dem Datenzugriffs-Schieberegister (54) des nachfolgenden Datenspeicherelements (52, 54, 56, 50, 150, 152, 58) zugeführt werden, wenn der Kreuzungsschalter des nachfolgenden Datenspeicherelements (52, 54, 56, 50, 150, 152, 58) nicht überkreuz geschaltet ist und Eingangsdaten vom Datenspeicher-Schieberegister (52) des nachfolgenden Datenspeicherelements (52, 54, 56, 50, 150, 152, 58) empfängt, wenn der Kreuzungsschalter (50) des vorhergehenden Datenspeicherelements (52, 54, 56, 50, 150, 152, 58) überkreuz geschaltet ist; und

daß das Datenzugriffs-Schieberegister (54) Ausgangsdaten als Eingangsdaten an das Datenzugriffs-Schieberegister (54) des nachfolgenden Datenspeicherelements (52, 54, 56, 50, 150, 152, 58) liefert, wenn der Kreuzungsschalter (50) nicht überkreuz geschaltet ist und Ausgangsdaten als Eingangsdaten an das Datenspeicher-Schieberegister (52) des nachfolgenden Datenspeicherelements (52, 54, 56, 50, 150, 152, 58) liefert, wenn der Kreuzungsschalter überkreuz geschaltet ist.

3. Integrierte Schaltung (10) nach Anspruch 2, dadurch gekennzeichnet,
daß eine Anordnung von Datenspeicherzellen (12, 16) vorgesehen ist, von denen jede Zelle (12, 16) eine Mehrzahl der Datenspeicherelemente (52, 54, 56, 50, 150, 152, 58) enthält und jeder Kreuzungsschalter (50) eine Koppellogik (50) aufweist, mit der wahlweise das nachfolgende Datenspeicherelement (52, 54, 56, 50, 150, 152, 58) entweder innerhalb der gleichen Zelle (12, 16) oder von einer angrenzenden Zelle (12, 16) ausgewählt wird.

4. Integrierte Schaltung (10) nach Anspruch 3, dadurch gekennzeichnet,
daß jede der Zellen (12, 16) eine Statusmaschine (58) enthält, die zum Betrieb der Koppellogik (50) angeschlossen ist und sowohl ein Globalsignal (36, 38) als auch ein Startsignal (26) von einer Nachbarzelle (12, 16) erhält; und

daß die Koppellogik (50) eine Datenvergleichsschaltung (72, 74, 76) zum Vergleichen der in die zugeordneten Schieberegister einfließenen und aus diesen herausfließenden Daten enthält und eine Anzeige (an 64) der Gleichheit oder Ungleichheit an die Statusmaschine (58) gibt, die abhängig von dem Empfang des Globalsignals (an 36, 38) und des Startsignals (an 26) von der Nachbarzelle (12, 16) anspricht und einen Funktionstest an der Zelle (12, 16) durchführt, ob diese funktioniert.

5. Integrierte Schaltung (10) nach Anspruch 4, dadurch gekennzeichnet,
daß die Statusmaschine (58) derart arbeitet, daß an jeder vorher nicht getesteten Zelle (12, 16) ein solcher Funktionstest durchgeführt wird und diese (über 52) an die Nachbarzelle (12, 16) angekoppelt wird, wenn der Test bestanden ist, so daß jede Zelle (12, 16), die einen solchen Test bestanden hat, in der Lage ist, das Startsignal (an 26) an eine Mehrzahl von anderen Nachbarzellen (12, 16) zu geben; und

daß jedesmal, wenn die Statusmaschine (58) das Globalsignal (an 36, 38) empfängt, sie (über 86) eine der anderen Nachbarzellen (12, 16) auswählt, um diesen das Startsignal (an 26) zuzuführen, wobei mindestens eine der Zellen (12, 16) der Anordnung mit Mitteln versehen ist, um das Startsignal von einem Eingangsport (14) zu empfangen und an diesen funktionell anzukoppeln.

6. Integrierte Schaltung nach Anspruch 4, dadurch gekennzeichnet, daß jede Zelle (12, 16) der Zellenanordnung (12, 16) vier Datumspeicherelemente (52) aufweist, und daß jede Zelle (12, 16) der Anordnung maximal vier Nachbarzellen (12, 16) hat.

7. Integrierte Schaltung nach Anspruch 6, dadurch gekennzeichnet, daß die Statusmaschine (58) eine Richtungszähleranordnung (86) aufweist, die abhängig von jedem Empfang des Globalsignals (an 38, 36) fortschaltet, um jede der Nachbarzellen (12, 16) zur Zuführung des Startsignals (an 26) nacheinander auszuwählen.

**Revendications**

1. Circuit intégré (10) comportant l'élément d'enregistrement de données (52, 54, 56, 50) avec: un registre à décalage (52) pour l'enregistrement de données, un registre à décalage (54) pour l'accès des données, un commutateur de croisement (50) pour croiser les sorties du registre à décalage d'enregistrement de données (52) et du registre à décalage d'accès de données (54) ainsi qu'un comparateur de données (150, 152, 58) pour faire des opérations de comparaison entre le premier bit du registre à décalage d'enregistrement de données (52) et la sortie du registre à décalage d'accès de données (54), le comparateur de données (150, 152, 58) fournissant un signal de sortie indiquant qu'une absence de coïncidence s'est produite au cours de cette opération, le circuit intégré (10) étant caractérisé en ce que l'élément d'enregistrement de données (52, 54, 56, 50, 150, 152) comporte un registre à décalage (56) de caractères de contrôle; le comparateur de données (150, 152, 58) répondant à la première présentation d'un premier caractère de contrôle ("10") au registre à décalage de caractères de contrôle (56) pour commencer cette opération de comparaison, ce comparateur de données (150, 152, 58) travaillant en réponse aux présentations suivantes de ce premier caractère de contrôle ("10") au registre de décalage de caractères de contrôle (56) pour alternativement suspendre et reprendre des opérations de comparaison, le commutateur de croisement (50) travaillant en réponse à la première présentation d'un second caractère de contrôle "11" au registre à décalage à caractères de contrôle (56) pour commencer le croisement si et seulement si le comparateur de données (150, 152, 58) ne fournit pas de sortie indiquant une absence de

EP 0 172 311 B1

coïncidence et le commutateur de croisement (50) peut être mis en oeuvre pour abandonner le croisement en réponse à la présentation suivante du second caractère de contrôle ("11") au registre à décalage de caractères de contrôle (56).

2. Circuit intégré (10) selon la revendication 1, caractérisé par un ensemble d'éléments d'enregistrement de données (52, 54, 56, 50, 150, 152, 58), chaque élément étant relié de manière concatenée avec un élément d'enregistrement de données (52, 54, 56, 50, 150, 152, 58) précédent et un élément d'enregistrement de données suivant (52, 54, 56, 50, 150, 152, 58), le registre à décalage de caractères de contrôle (56) recevant les caractères de contrôle du registre à décalage de caractères de contrôle (56) de l'élément d'enregistrement de données, précédent (52, 54, 56, 50, 150, 152, 58) et faisant passer les caractères de contrôle vers le registre à décalage de caractères de contrôle (56) dans l'élément d'enregistrement de données, suivant (52, 54, 56, 50, 150, 152, 58), le registre à décalage d'enregistrement de données (52) recevant les données d'entrée du registre à décalage d'enregistrement de données (52) dans l'élément d'enregistrement de données précédent (52, 54, 56, 50, 150, 152, 58) lorsque le commutateur de croisement (50) de l'élément d'enregistrement de données précédent (52, 54, 56, 50, 150, 152, 58) n'est pas en mesure d'effectuer un croisement et pour recevoir les données d'entrée du registre à décalage d'accès de données (54) de l'élément d'enregistrement de données précédent (52, 54, 56, 50, 150, 152, 58) lorsque le commutateur de croisement (50) de l'élément d'enregistrement de données précédent (52, 54, 56, 50, 150, 152, 58) est en mesure d'effectuer un croisement, le registre à décalage d'enregistrement de données (52) fournissant une donnée de sortie comme entrée au registre à décalage d'enregistrement de données (52) de l'élément d'enregistrement données suivant (52, 54, 56, 50, 150, 152, 58) lorsque le commutateur de croisement (50) n'est pas en mesure d'effectuer un croisement et pour fournir une donnée de sortie comme entrée au registre à décalage d'accès de données (54) de l'élément d'enregistrement de données suivant (52, 54, 56, 50, 150, 152, 58) lorsque le commutateur de croisement (50) effectue un croisement, le registre à décalage d'accès de données (54) recevant les données d'entrée du registre à décalage d'accès de données (54) de l'élément d'enregistrement de données précédent (52, 54, 56, 50, 150, 152, 58) lorsque le commutateur de croisement (50) de l'élément d'enregistrement de données précédent (52, 54, 56, 50, 150, 152, 58) n'est pas en mesure de d'effectuer un croisement et pour recevoir les données d'entrée du registre à décalage d'enregistrement de données (52) de l'élément d'enregistrement de données précédent (52, 54, 56, 50, 150, 152, 58) lorsque le commutateur de croisement (50) de cet élément d'enregistrement précédent (52, 54, 56, 50, 150, 152, 58) est en mesure d'effectuer un croisement, et le registre à décalage d'accès de données (54) fournit une donnée de sortie comme entrée au registre à décalage d'accès de données (54) de l'élément d'enregistrement de données suivant (52, 54, 56, 50, 150, 152, 58) lorsque le commutateur de croisement (50) n'est pas en mesure d'effectuer un croisement et pour fournir la donnée de sortie comme entrée au registre à décalage d'enregistrement de données (52) de l'élément d'enregistrement de données suivant (52, 54, 56, 50, 150, 152, 58) lorsque le commutateur de croiseme (50) passe en croisement.

3. Circuit intégré (10) selon la revendication 2, caractérisé en ce qu'il comporte un réseau de cellules d'enregistrement de données (12, 16) dans lequel les cellules (12, 16) sont formées d'un ensemble d'éléments d'enregistrement de données (52, 54, 56, 50, 150, 152, 58) et le commutateur de croisement (50) comporte une logique de couplage (50) mise en oeuvre sélectivement pour choisir l'élément d'enregistrement de données suivant (52, 54, 56, 50, 150, 152, 58) soit dans la même cellule (12, 16), soit d'une cellule adjacente continue (12, 16).

4. Circuit intégré (10) selon la revendication 3, caractérisé en ce que chacune des cellules (12, 16) comporte une machine d'état (58) couplée de manière à coopérer avec la logique de couplage (50) et pour recevoir un signal global (36, 38) et un signal d'initialisation (26) d'une cellule voisine (12, 16) et la logique de couplage (50) comporte un moyen de comparaison de données (72, 74, 76) pour comparer les données qui entrent et sortent des registres à décalage (52, 54) associés avec ceux-ci et fournissant une indication (sur 64) de l'égalité ou de l'inégalité avec la machine d'état (58), en réponse à la réception du signal global (sur 36, 38) et du signal d'initialisation (sur 26) de la cellule voisine (12, 16), la machine d'état (58) effectuant un test fonctionnel sur la cellule (12, 16) pour déterminer si cette cellule peut fonctionner.

5. Circuit intégré (10) selon la revendication 4, caractérisé en ce que la machine d'état (58) travaille de manière que toute cellule précédemment non testée (12, 16) subisse le test fonctionnel et soit couplée fonctionnellement (par 52) sur n'importe quelle cellule (12, 16) qui a subi le test et soit capable de fournir le signal d'initialisation (sur 26) à un ensemble d'autres cellules voisines (12, 16) de façon que chaque fois qu'elle reçoit le signal global (sur 36, 38), la machine d'état (58) choisit (en utilisant 86) l'une des autres cellules voisines (12, 16) pour fournir le signal d'initialisation (sur 26) au moins l'une des cellules (12, 16) du réseau comportant des moyens pour recevoir le signal d'initialisation du port d'entrée (14) et être couplé fonctionnellement sur celui-ci.

6. Circuit intégré selon la revendication 4, caractérisé en ce que chaque cellule (12, 16) du réseau de cellules (12, 16) comprend quatre éléments d'enregistrement de données (52) et chaque cellule (12, 16) du réseau a un nombre maximum de quatre cellules voisines (12, 16).

7. Circuit intégré selon la revendication 6, caractérisé en ce que la machine d'état (58) comporte un compteur de direction (86) commandé de manière incrémentale par chaque réception du signal global (sur 38, 36) pour choisir chacune des cellules voisines (12, 16) à son tour pour lui fournir le signal d'initialisation (sur 26).

19

*Fig. 1.*

10

14

16

12

*Fig. 3.*

40

12

12

200
220
240
260
280
320
300

380
360
340

14

Fig. 2.

Fig 4.

Fig.5A.

Fig.5B.

*Fig.5C.* 32N 30N 28N 24N 22N 20N

50N

54WN 56WN 52WN 56NE 54NE

52NE

*Fig.5D.* 32N 30N 28N 24N 22N 20N

50N

54WN 56WN 52WN 56NE 54NE

52NE

Fig.5E.

32N 30N 28N 24N 22N 20N

50N

54WN 56WN 52WN 56NE 54NE 52NE

Fig.5F.

32N 30N 28N 24N 22N 20N

50N

54WN 56WN 52WN 56NE 54NE 52NE

Fig.6.

Fig. 7.

32N 30N 28N 24N 22N 20N

72 74

76

50N

54WN 56WN

52WN

64N

56NE 54NE

52NE

Fig. 12.

10

200
220
240
260
380
360
340
280
300
320

14

120 122

**Fig.8.**

Fig. 9A.    Fig. 9B.    Fig. 9C.

Fig. 9D.    Fig. 9E.

Fig. 9F.    Fig. 9G.

Fig. 9H.    Fig. 9I.

*Fig. 10.*

*Fig. 11.*

*Fig. 17.*

Fig. 9J.

Fig. 9K.

Fig. 9L.

Fig. 13

132

130

120

Fig. 14.

SI

52 52 52 52 SO

n n n n

FI 54 54 54 54 FO

Fig. 15.

SI

52 52 52 52 SO

n n n n

FI 54 54 54 54 FO

## Fig. 16.

Fig. 18.

Fig. 19A.

Fig. 19B.

Fig. 19C.

*Fig.20.*